# EUROPEAN PATENT APPLICATION

(11) **EP 4 718 204 A1**
(43) Date of publication of application: **01.04.2026**
(21) Application number: 24826124.0
(22) Date of filing: 13.05.2024
(51) Int. Cl.: G06F 1/16, G06F 3/0354, G06F 1/3203, G01P 15/00

(54) **DIGITAL PEN AND ELECTRONIC DEVICE COMPRISING SAME**

(30) Priority: 19.06.2023 KR 20230078264; 17.07.2023 KR 20230092284
(71) Applicant: Samsung Electronics Co., Ltd., Suwon-si, Gyeonggi-do 16677 (KR)
(72) Inventor: JEON, Gyuyeon, Suwon-si Gyeonggi-do 16677 (KR); PARK, Jongdo, Suwon-si Gyeonggi-do 16677 (KR); RHEE, Minsu, Suwon-si Gyeonggi-do 16677 (KR); LIM, Gun, Suwon-si Gyeonggi-do 16677 (KR)
(74) Representative: Gulde & Partner
(86) International application number: PCT/KR2024/006474
(87) International publication number: WO 2024/262802

(57) **Abstract**

According to an embodiment of the present disclosure, an electronic device may comprise: a housing including a first housing, a second housing, and a hinge structure which relatively rotatably connects the first housing and the second housing to each other; a display disposed in the housing, the display including a first display area disposed on the first housing, a second display area disposed on the second housing, and a folding area configured to be at least partially foldable; and at least one electromagnet disposed between the hinge structure and the folding area, wherein the folding area is configured to form an accommodation space in which a digital pen including at least one magnetic member can be accommodated when the housing is in a folded state. Various other embodiments may also be possible.

## Description

### [Technical Field]

Various embodiments of the disclosure relate to an electronic device, e.g., a digital pen and an electronic device including the same.

### [Background Art]

Advancing information communication and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function for mobile banking, and a scheduling or e-wallet function. These electronic devices have been downsized to be conveniently carried by users.

As mobile communication services extend up to multimedia service sectors, the display of the electronic device may be increased to allow the user satisfactory use of multimedia services as well as voice call or text messaging services. Accordingly, a foldable flexible display may be disposed on the entire area of the housing structure separated to be foldable.

The above-described information may be provided as related art for the purpose of helping understanding of the disclosure. No claim or determination is made as to whether any of the foregoing is applicable as background art in relation to the disclosure.

### [Detailed Description of the Invention]

### [Technical Solution]

According to an embodiment of the disclosure, an electronic device includes a housing including a first housing, a second housing, and a hinge structure rotatably connecting the first housing and the second housing relative to each other, a display disposed on the housing, the display including a first display area disposed on the first housing, a second display area disposed on the second housing, and a folding area configured to be at least partially foldable, and at least one electromagnet disposed between the hinge structure and the folding area. When the housing is in a folded state, the folding area may be configured to form an accommodation space capable of accommodating a digital pen including at least one magnetic member when the housing is in a folded state.

According to an embodiment of the disclosure, an electronic device includes a housing including a first housing, a second housing, a third housing, a first hinge structure rotatably connecting the first housing and the second housing relative to each other, and a second hinge structure rotatably connecting the second housing and the third housing relative to each other, a display disposed on the housing, the display including a first display area disposed on the first housing, a second display area disposed on the second housing, a third display area disposed on the third housing, and a folding area configured to be at least partially foldable, and at least one electromagnet disposed on the first hinge structure or the second hinge structure. When the housing is in a folded state, the folding area may be configured to form an accommodation space capable of accommodating a digital pen including at least one magnetic member when the housing is in a folded state.

According to an embodiment of the disclosure, an electronic device includes a housing including a first housing, a second housing, and a hinge structure rotatably connecting the first housing and the second housing relative to each other, a display disposed on the housing, the display including a first display area disposed on the first housing, a second display area disposed on the second housing, and a folding area configured to be at least partially foldable, at least one electromagnet disposed between the hinge structure and the folding area, a battery configured to apply current to the at least one electromagnet, at least one processor and a memory. The at least one processor may be configured to control the battery to apply current to the at least one electromagnet when a non-use event of the digital pen occurs, and to control the battery to cut off current to the at least one electromagnet when a use event of the digital pen occurs.

### [Brief Description of Drawings]

FIG. 1 is a block diagram illustrating an electronic device in a network environment according to an embodiment.
FIG. 2 is a view illustrating an unfolded state of an electronic device according to an embodiment of the disclosure.
FIG. 3 is a view illustrating a folded state of an electronic device according to an embodiment of the disclosure.
FIG. 4 is an exploded perspective view illustrating an electronic device according to an embodiment of the disclosure.
FIG. 5 is an exploded perspective view illustrating a digital pen according to an embodiment of the disclosure.
FIG. 6 is a block diagram illustrating a digital pen according to an embodiment of the disclosure.
FIG. 7 is a view illustrating a flexible printed circuit board and at least one electromagnet of an electronic device according to an embodiment of the disclosure.
FIG. 8 is a plan view illustrating a flexible printed circuit board of an electronic device according to an embodiment of the disclosure.
FIG. 9 is a plan view illustrating a flexible printed circuit board of an electronic device according to an embodiment of the disclosure.
FIG. 10 is a schematic view illustrating an electronic device and a digital pen according to an embodiment of the disclosure.
FIG. 11 is a plan view illustrating a flexible printed circuit board of an electronic device according to an embodiment of the disclosure.
FIG. 12 is a plan view illustrating a flexible printed circuit board of an electronic device according to an embodiment of the disclosure.
FIG. 13 is a schematic view illustrating an electronic device and a digital pen according to an embodiment of the disclosure.
FIG. 14A is a view illustrating an electronic device including a plurality of housings according to an embodiment of the disclosure.
FIG. 14B is a view illustrating an electronic device including a plurality of housings according to an embodiment of the disclosure.
FIG. 14C is a view illustrating a digital pen and an electronic device according to an embodiment of the disclosure.
FIG. 14D is a view illustrating a digital pen and an electronic device according to an embodiment of the disclosure.
FIG. 15 is a cross-sectional view illustrating a folded state of a digital pen and an electronic device according to an embodiment of the disclosure.
FIG. 16 is a cross-sectional view illustrating a folded state of a digital pen and an electronic device according to an embodiment of the disclosure.
FIG. 17A is a view illustrating an electronic device including a plurality of housings according to an embodiment of the disclosure.
FIG. 17B is a view illustrating an electronic device including a plurality of housings according to an embodiment of the disclosure.
FIG. 17C is a view illustrating a digital pen and an electronic device according to an embodiment of the disclosure.
FIG. 17D is a view illustrating a digital pen and an electronic device according to an embodiment of the disclosure.
FIG. 18 is a cross-sectional view illustrating a folded state of a digital pen and an electronic device according to an embodiment of the disclosure.
FIG. 19 is a cross-sectional view illustrating a folded state of a digital pen and an electronic device according to an embodiment of the disclosure.
FIG. 20A is a view illustrating an electronic device including a plurality of housings according to an embodiment of the disclosure.
FIG. 20B is a view illustrating an electronic device including a plurality of housings according to an embodiment of the disclosure.
FIG. 20C is a view illustrating a digital pen and an electronic device according to an embodiment of the disclosure.
FIG. 21 is a cross-sectional view illustrating a folded state of a digital pen and an electronic device according to an embodiment of the disclosure.
FIG. 22 is a cross-sectional view illustrating a folded state of a digital pen and an electronic device according to an embodiment of the disclosure.
FIG. 23 is a flowchart illustrating a current application process to an electromagnet of an electronic device according to an embodiment of the disclosure.
FIG. 24 is a flowchart illustrating a current application process to an electromagnet of an electronic device according to an embodiment of the disclosure.
FIG. 25A is a flowchart illustrating a current application process to an electromagnet of an electronic device according to an embodiment of the disclosure.
FIG. 25B is a perspective view illustrating a digital pen and an electronic device according to an embodiment of the disclosure.
FIG. 25C is a perspective view illustrating a digital pen and an electronic device according to an embodiment of the disclosure.
FIG. 26 is a flowchart illustrating a current application process to an electromagnet of an electronic device according to an embodiment of the disclosure.

### [Mode for Carrying out the Invention]

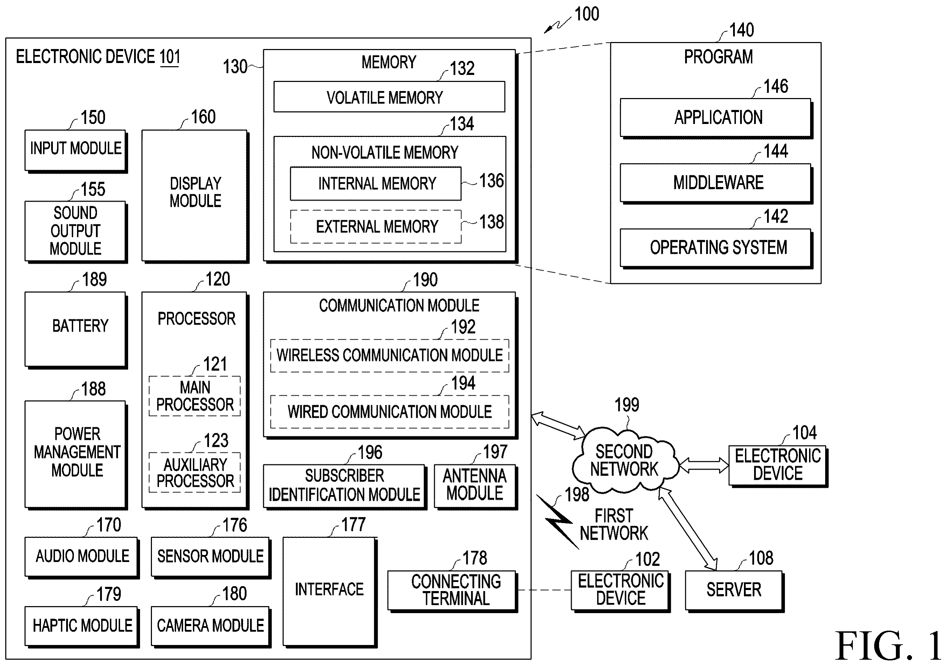

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., the program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

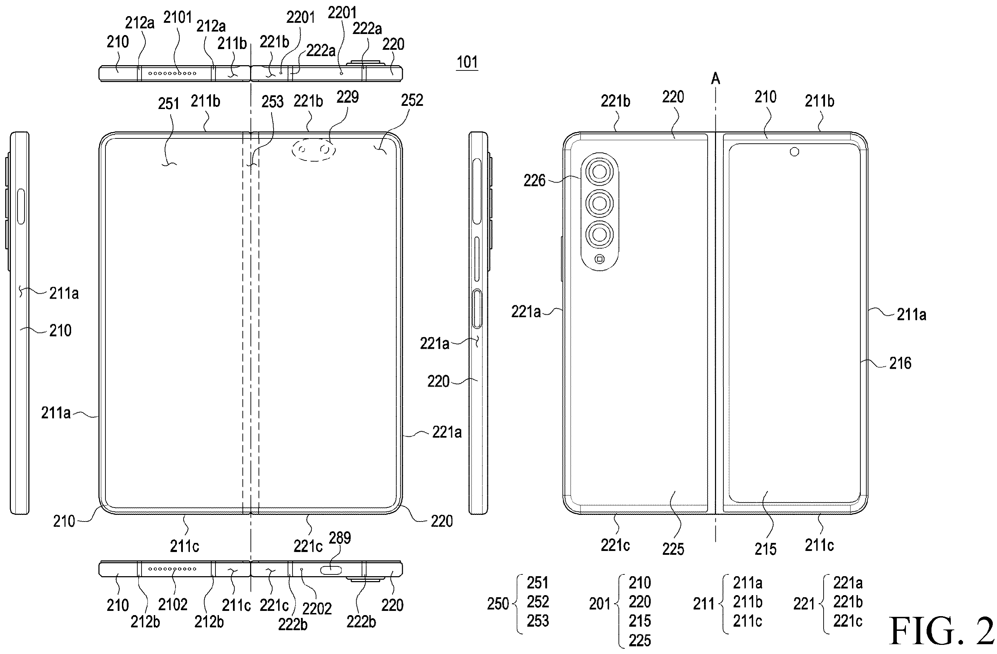

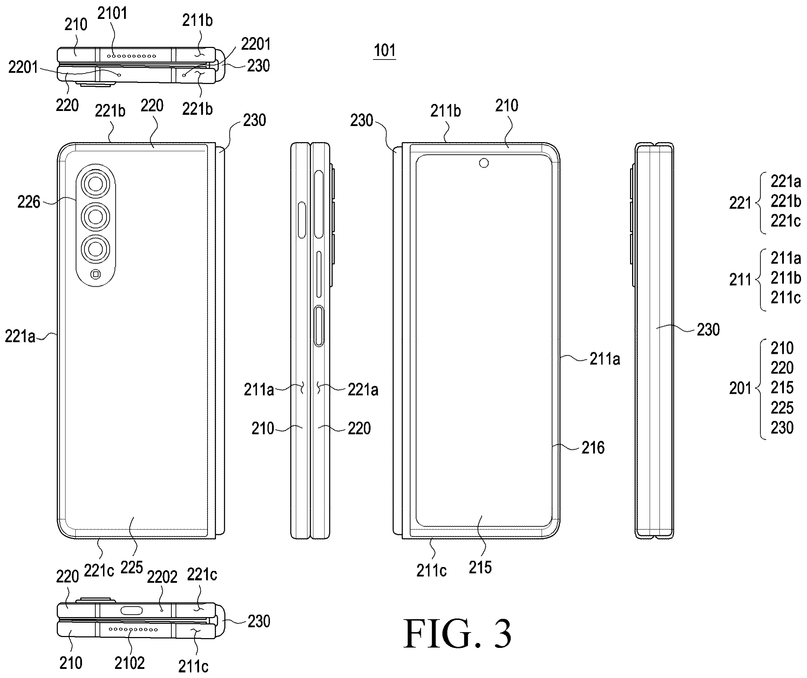

FIG. 2 is a view illustrating an unfolded state of an electronic device according to an embodiment of the disclosure. FIG. 3 is a view illustrating a folded state of an electronic device according to an embodiment of the disclosure.

FIG. 2 is a view illustrating an unfolded status among folding states of an electronic device (or a foldable electronic device) according to an embodiment of the disclosure. FIG. 3 is a view illustrating a folded status of the electronic device (or a foldable electronic device) according to an embodiment of the disclosure. The electronic device 101 of FIGS. 2 and 3, as an example of the electronic device 101 shown in FIG. 1, may be a foldable or bendable electronic device.

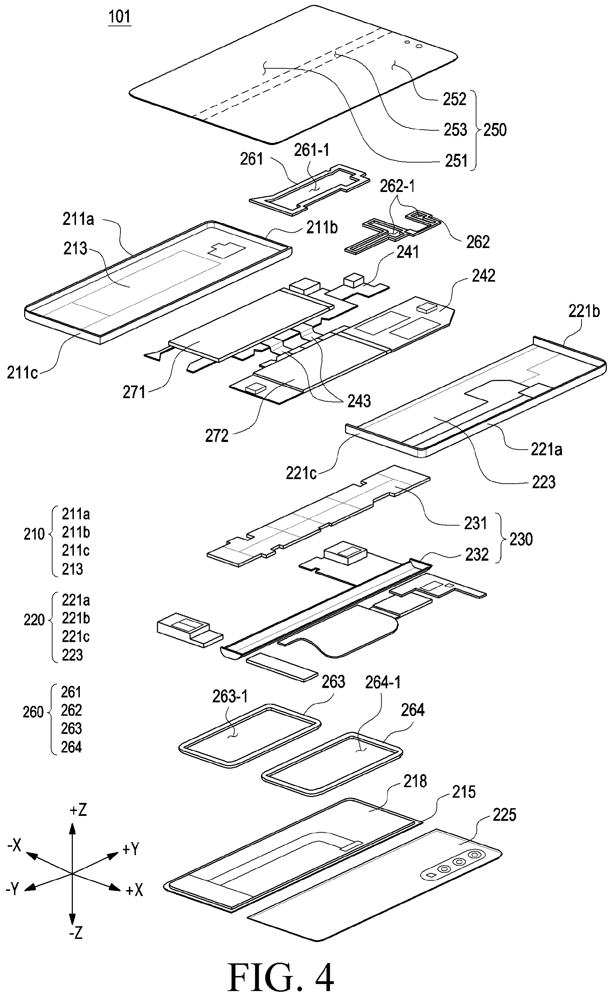

The embodiments of FIGS. 2 and 3 may be combined with the embodiment of FIG. 1 or the embodiments of FIGS. 4 to 26.

The configuration of the electronic device 101 of FIGS. 2 and 3 may be identical in whole or part to the configuration of the electronic device 101 of FIG. 1.

Referring to FIGS. 2 and 3, according to an embodiment, an electronic device 101 may include a foldable housing 201 and a flexible or foldable display 250 (hereinafter, simply " flexible display 250") (e.g., the display module 160 of FIG. 1) disposed in a space formed by the foldable housing 201. According to an embodiment, the surface where the flexible display 250 is disposed (or the surface where the flexible display 250 is viewed from the outside of the electronic device 101) may be defined as the front surface of the electronic device 101. The opposite surface of the front surface may be defined as a rear surface of the electronic device 101. The surface surrounding the space between the front and back surfaces may be defined as a side surface of the electronic device 101.

According to an embodiment, the foldable housing 201 may include a first housing 210, a second housing 220 including a sensor area 229, a first rear cover 215, a second rear cover 225, and a hinge assembly 230. According to an embodiment, the hinge assembly 230 may include a hinge cover (e.g., the hinge cover 232 of FIG. 4) that covers the foldable portion of the foldable housing 201. The foldable housing 201 of the electronic device 101 are not limited to the shape and coupling shown in FIGS. 2 and 3 but may rather be implemented in other shapes or via a combination and/or coupling of other components. For example, in an embodiment, the first housing 210 and the first rear cover 215 may be integrally formed with each other, and the second housing 220 and the second rear cover 225 may be integrally formed with each other.

According to an embodiment, an illuminance sensor and an image sensor may be disposed in the sensor area 222 The illuminance sensor may detect the amount of light around the electronic device 101, and the image sensor may convert light incident through the camera lens into a digital signal. The illuminance sensor and the image sensor may be visually exposed through the flexible display 250. According to an embodiment, the illuminance sensor and the image sensor may not be visually exposed. For example, the camera may be configured as an under display camera (UDC). Pixels in one area of the flexible display 250 corresponding to the location of the UDC may be configured to differ from pixels in other areas, so that the image sensor and/or camera may not be visually exposed.

According to an embodiment, the first housing 210 may be connected to the hinge assembly 230 and may include a first front surface facing in a first direction and a first rear surface facing in a direction opposite to the first direction. The second housing 220 may be connected to the hinge assembly 230 and may include a second front surface facing in a second direction and a second rear surface facing in a direction opposite to the second direction. The first housing 210 may rotate about the hinge assembly 230 with respect to the second housing 220. The second housing 220 may rotate about the hinge assembly 230 with respect to the first housing 210. The electronic device 101 may transform to a folded status or an unfolded status. For example, the folded state of the electronic device 101 may be defined and/or referred to as a folded state of the housing 201. The unfolded state of the electronic device 101 may be defined and/or referred to as an unfolded state of the housing 201.

According to an embodiment, the first housing 210 may include a 1-1th side surface 211a disposed to be spaced apart from and in parallel to the folding axis A of the hinge assembly 230 between the first front surface and the first rear surface, and the second housing 220 may include a 2-1th side surface 221a disposed to be spaced apart from and in parallel to the folding axis A of the hinge assembly 230 between the second front surface and the second rear surface. Further, the first housing 210 may include a 1-2th side surface 211b perpendicular to the 1-1th side surface 211a and having an end connected with the 1-1th side surface 211a and another end connected with the hinge assembly 230 and a 1-3th side surface 211c perpendicular to the 1-1th side surface 211a and having an end connected with the 1-1th side surface 211a and another end connected with the hinge assembly 230 and spaced apart from and in parallel to the 1-2th side surface 211b. The second housing 220 may include a 2-2th side surface 221b perpendicular to the 2-1th side surface 221a and having an end connected with the 2-1th side surface 221a and another end connected with the hinge assembly 230 and a 2-3th side surface 221c perpendicular to the 2-1th side surface 221a and having an end connected with the 2-1th side surface 221a and another end connected with the hinge assembly 230 and spaced apart from and in parallel to the 2-2th side surface 221b. When the first housing 210 is folded about the hinge assembly 230 with respect to the second housing 220 (e.g., FIG. 3), the 1-1th side surface 211a may approach the 2-1th side surface 221a and, when the first housing 210 is unfolded about the hinge assembly 230 with respect to the second housing 220 (e.g., FIG. 2), the 1-1th side surface 211a may move away from the 2-1th side surface 221a.

According to an embodiment, in the fully folded state of the electronic device 101, the first front surface may face the second front surface and, in the fully unfolded state, the first direction may be identical to the second direction. In the fully unfolded state, the distance between the 1-1th side surface 211a and the 2-1th side surface 221a may be the largest.

According to an embodiment, the first housing 210 and the second housing 220 are disposed on two opposite sides of the folding axis A and be overall symmetrical in shape with respect to the folding axis A. As described below, the angle or distance between the first housing 210 and the second housing 220 may be varied depending on whether the electronic device 101 is in the unfolded state, the folded state, or the partially unfolded (or partially folded) intermediate state.

According to an embodiment, as shown in FIG. 2, the first housing 210 and the second housing 220 together may form a recess to receive the flexible display 250. According to an embodiment, at least a portion of the first housing 210 and the second housing 220 may be formed of a metallic material or a non-metallic material having rigidity of a selected size for supporting the flexible display 250. At least a portion formed of metal may provide a ground plane of the electronic device 101 and may be electrically connected with a ground line formed on the printed circuit board disposed in the foldable housing 201.

According to an embodiment, a protection member may be disposed outside the flexible display 250. The protection member may be formed integrally with the side surface of the foldable housing 201 or as a separate structure. The flexible display 250 may not adhere to the side surface of the foldable housing 201 and/or the protection member. A gap may be formed between the flexible display 250 and the protection member. The protection member may be configured to cover the internal configuration of the electronic device 101 from the outside or to protect the internal configuration of the electronic device 101 from external impact. According to an embodiment, the protection member may be configured to cover the line disposed on the flexible display 250 from the outside or to protect it from an external impact.

According to an embodiment, the first rear cover 215 may be disposed on one side of the folding axis A on the rear surface of the electronic device 101 and have, e.g., a substantially rectangular periphery which may be surrounded by the first housing 210. Similarly, the second rear cover 225 may be disposed on the opposite side of the folding axis A on the rear surface of the electronic device 101 and its periphery may be surrounded by the second housing 220.

According to an embodiment, the first rear cover 215 and the second rear cover 225 may be substantially symmetrical in shape with respect to the folding axis A. However, the first rear cover 215 and the second rear cover 225 are not necessarily symmetrical in shape. In an embodiment, the electronic device 101 may include the first rear cover 215 and the second rear cover 225 in various shapes. In an embodiment, the first rear cover 215 may be integrally formed with the first housing 210, and the second rear cover 225 may be integrally formed with the second housing 220.

According to an embodiment, the first rear cover 215, the second rear cover 225, the first housing 210, and the second housing 220 may form a space where various components (e.g., a printed circuit board or battery) of the electronic device 101 may be disposed. According to an embodiment, one or more components may be disposed or visually exposed on the rear surface of the electronic device 101. For example, at least a portion of a sub display (e.g., the sub display 218 of FIG. 4) may be visually exposed through a first back surface area 216 of the first back cover 215. For example, one or more components or sensors may be visually exposed through a second rear surface area 226 of the second rear cover 225. In an embodiment, the sensor may include a proximity sensor and/or a rear camera.

According to an embodiment, the front camera disposed on the front surface (e.g., the second front surface) of the electronic device 101 or the rear camera exposed through the second rear surface area 226 of the second rear cover 225 may include one or more lenses, an image sensor, and/or an image signal processor. The flash may include, e.g., a light emitting diode or a xenon lamp. In an embodiment, two or more lenses (infrared cameras, wide-angle and telephoto lenses) and image sensors may be disposed on one surface of the electronic device 101.

Referring to FIG. 3, the hinge cover (e.g., the hinge cover 232 of FIG. 4) included in the hinge assembly 230 may be disposed between the first housing 210 and the second housing 220 to hide the internal components (e.g., the hinge structure 231 of FIG. 4). According to an embodiment, the hinge assembly 230 may be hidden by a portion of the first housing 210 and second housing 220 or be exposed to the outside depending on the state (the unfolded state, intermediate state, or folded state) of the electronic device 101.

According to an embodiment, as shown in FIG. 2, in the unfolded state (e.g., a fully unfolded state) of the electronic device 101, the hinge assembly 230 may be hidden not to be exposed by the first housing 210 and the second housing 220. According to an embodiment, as shown in FIG. 3, in the folded state (e.g., a fully folded state) of the electronic device 101, the hinge assembly 230 may be exposed to the outside between the first housing 210 and the second housing 220. As an embodiment, in the intermediate state in which the first housing 210 and the second housing 220 are folded with a certain angle, the hinge assembly 230 may be partially exposed to the outside between the first housing 210 and the second housing 220. However, in this case, the exposed area may be smaller than that in the completely folded state. In an embodiment, the hinge assembly 230 may include a curved surface.

In an embodiment, the flexible display 250 may be disposed in a space formed by the foldable housing 201. For example, the flexible display 250 may be seated in a recess formed by the foldable housing 201 and may be seen from the outside through the front surface (e.g., the first front surface and/or the second front surface) of the electronic device 101. According to an embodiment, the flexible display 250 may constitute most of the front surface (e.g., the first front surface and/or the second front surface) of the electronic device 101. Accordingly, the front surface (e.g., the first front surface and/or the second front surface) of the electronic device 101 may include the flexible display 250 and a partial area of the first housing 210 and a partial area of the second housing 220 adjacent to the flexible display 250. The rear surface (e.g., the first rear surface and/or second rear surface) of the electronic device 101 may include the first rear cover 215, a partial area of the first housing 210 adjacent to the first rear cover 215, the second rear cover 225, and a partial area of the second housing 220 adjacent to the second rear cover 225.

According to an embodiment, the flexible display 250 may refer to a display in which at least a partial area thereof may be deformed into a flat surface or a curved surface. According to an embodiment, the flexible display 250 may include a folding area 253, a first display area 251 disposed on one side of the folding area 253 (e.g., the left side of the folding area 253 of FIG. 2), and a second display area 252 disposed on the opposite side of the folding area 253 (e.g., the right side of the folding area 253 of FIG. 2).

According to an embodiment, the first display area 251 may be disposed on the first housing 210, and the second display area 252 may be disposed on the second housing 220. According to an embodiment, the folding area 253 may connect the first display area 251 and the second display area 252, and may be disposed on the hinge assembly 230.

The segmentation of the flexible display 250 as shown in FIG. 2 is merely an example, and the display 250 may be divided into a plurality of (e.g., four or more, or two) areas depending on the structure or function of the display 250. For example, in the embodiment illustrated in FIG. 2, the area of the flexible display 250 may be divided by the folding area 253 extending parallel to the folding axis A, but the area of the flexible display 250 may be divided by another folding axis (e.g., a folding axis parallel to the width direction of the electronic device).

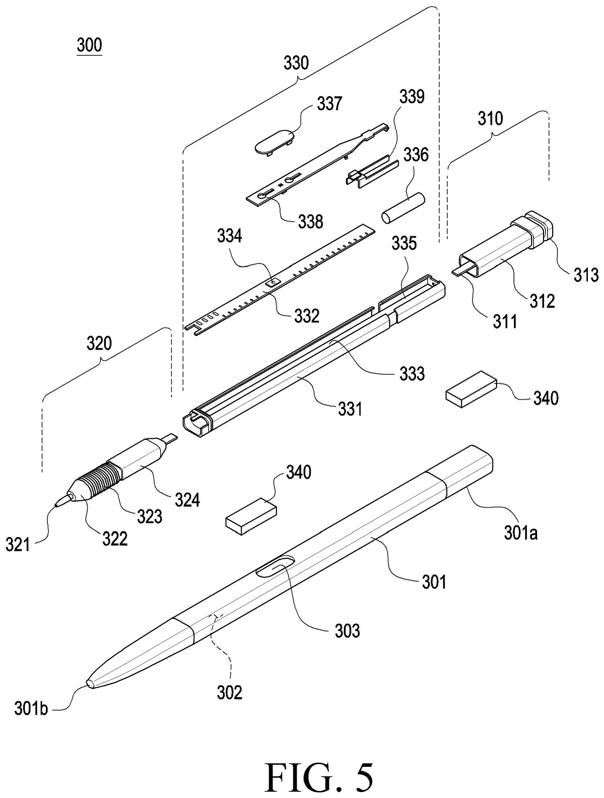

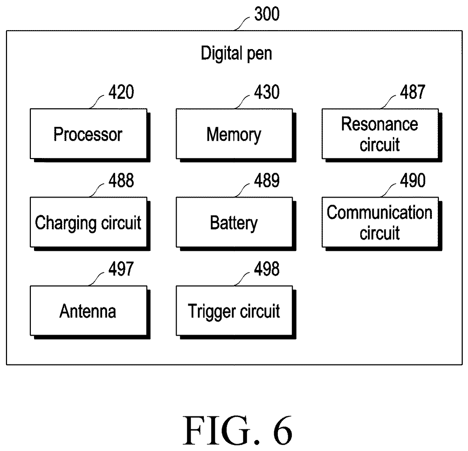

According to an embodiment, the flexible display 250 may be coupled or disposed adjacent to a touch panel provided with a touch sensing circuit and a pressure sensor capable of measuring the intensity (pressure) of the touch. For example, as an example of the touch panel, the flexible display 250 may be coupled to or disposed adjacent to an electromagnetic induction panel for detecting an electromagnetic resonance (EMR)-type stylus pen (e.g., the digital pen 300 of FIGS. 5 and 6).

According to an embodiment, the first display area 251 and the second display area 252 may be overall symmetrical in shape with respect to the folding area 253.

Described below are the operation of the first housing 210 and the second housing 220 and each area of the flexible display 250 depending on the state (e.g., the folded state, unfolded state, or intermediate state) of the electronic device 101.

According to an embodiment, when the electronic device 101 is in the unfolded state (e.g., FIG. 2), the first housing 210 and the second housing 220 may be disposed to face in the same direction while forming an angle of 180 degrees. The surface of the first display area 251 and the surface of the second display area 252 of the flexible display 250 may be angled at 180 degrees therebetween while facing in the same direction (e.g., forward of the front surface of the electronic device). In this case, the folding area 253 may form the same plane with the first display area 251 and the second display area 252.

According to an embodiment, when the electronic device 101 is in the folded state (e.g., FIG. 3), the first housing 210 and the second housing 220 may be disposed to face each other. The surface of the first display area 251 and the surface of the second display area 252 of the flexible display 250 may face each other while forming a narrow angle (e.g., between 0 degrees and 10 degrees). At least a portion of the folding area 253 may be formed as a curve having a predetermined curvature.

According to an embodiment, when the electronic device 101 is in the intermediate state, the first housing 210 and the second housing 220 may be disposed at a certain angle. The surface of the first display area 251 and the surface of the second display area 252 of the flexible display 250 may form an angle larger than that in the folded state and smaller than that in the unfolded state. The folding area 253 may at least partially have a curved surface with a predetermined curvature and, in this case, the curvature may be smaller than that when it is in the folded state.

According to an embodiment, the first housing 210 may include first housing holes 2101 and 2102. According to an embodiment, the first housing holes 2101 and 2102 may include a1-1th housing hole 2101 formed in the 1-2th side surface 211b of the first housing 210 and a 1-2th housing hole 2102 formed in the 1-3th side surface 211c of the first housing 210.

According to an embodiment, the 1-2th side surface 211b of the first housing 210 may include a 1-1th segmenter 212a formed of a non-metallic material. According to an embodiment, a pair of 1-1th segmenters 212a spaced apart from each other may be provided. According to an embodiment, the 1-1th housing hole 2101 may be formed between the pair of 1-1th segmenters 212a.

According to an embodiment, the 1-3th side surface 211c of the first housing 210 may include a 1-2th segmenter 212b formed of a non-metallic material. According to an embodiment, a pair of 1-2th segmenters 212b spaced apart from each other may be provided. According to an embodiment, the 1-2th housing hole 2102 may be formed between the pair of 1-2th segmenters 212b.

According to an embodiment, the number of at least one 1-1th housing hole 2101 may be equal to the number of at least one 1-2th housing hole 2102.

According to an embodiment, the 1-2th side surface 211b and the 1-3th side surface 211c may be disposed in parallel. According to an embodiment, the plurality of 1-1th housing holes 2101 and the plurality of 1-2th housing holes 2102 may be disposed to overlap each other with respect to the length direction (e.g., Y-axis direction of FIG. 4) of the electronic device 101. For example, the plurality of 1-1th housing holes 2101 may be disposed to correspond to the plurality of 1-2th housing holes 2102, respectively, in the length direction (e.g., the Y axis direction of FIG. 4) of the electronic device 101.

According to an embodiment, the plurality of 1-1th housing holes 2101 may be disposed on a straight line with respect to the width direction (e.g., the X axis direction of FIG. 4) of the electronic device 101 (or first housing 210). According to an embodiment, the plurality of 1-2th housing holes 2102 may be disposed on a straight line with respect to the width direction (e.g., the X axis direction of FIG. 4) of the electronic device 101 (or first housing 210).

According to an embodiment, the second housing 220 may include second housing holes 2201 and 2204. According to an embodiment, the second housing holes 2201 and 2204 may include a 2-1th housing hole 2201 formed in the 2-2th side surface 221b of the second housing 220 and a 2-2th housing hole 2204 formed in the 2-3th side surface 221c of the second housing 220.

According to an embodiment, the 2-2th side surface 221b of the second housing 220 may include a 2-1th segmenter 222a formed of a non-metallic material. According to an embodiment, a pair of 2-1th segmenters 222a spaced apart from each other may be provided. According to an embodiment, a portion of the 2-1th housing hole 2201 may be formed between the pair of 2-1th segmenters 222a, and the remaining portion of the 2-1th housing hole 2201 may be formed between the folding axis A (or the hinge assembly 230) and any one of the 2-1th segmenters 222a.

According to an embodiment, the 2-3th side surface 221c of the second housing 220 may include a 2-2th segmenter 222b formed of a non-metallic material. According to an embodiment, a pair of 2-2th segmenters 222b spaced apart from each other may be provided. According to an embodiment, the 2-1th housing hole 2201 may be formed between the pair of 2-2th segmenters 222b.

According to an embodiment, the 2-3th side surface 221c of the second housing 220 may include a connection terminal 289 (e.g., the connection terminal 178 of FIG. 1).

In the following description of the drawings, illustrated is a spatial coordinate system defined by an X-axis, a Y-axis and a Z-axis orthogonal to each other. Here, the X-axis may indicate the width direction of the components of the electronic device or the electronic device, the Y-axis may indicate the length direction of the components of the electronic device or the electronic device, and the Z-axis may indicate the height (or thickness) direction of the components of the electronic device or the electronic device. In describing an embodiment of the disclosure, the 'first direction and the second direction' may mean directions parallel to the Z-axis.

FIG. 4 is an exploded perspective view illustrating an electronic device according to an embodiment of the disclosure.

The embodiment of FIG. 4 may be combinable with the embodiments of FIGS. 1 to 3, or the embodiments of FIGS. 5 to 26.

Referring to FIG. 4, an electronic device 101 (e.g., the electronic device 101 of FIGS. 1 to 3) may include a foldable housing 201, a first housing 210, a second housing 220, a hinge assembly 230, a flexible display 250, a first printed circuit board 241, a second printed circuit board 242, a waterproofing member 260, a first battery 271, or a second battery 272.

The configuration of the foldable housing 201, the first housing 210, the second housing 220, the hinge assembly 230, and the flexible display 250 of FIG. 4 may be identical in whole or part to the configuration of the foldable housing 201, the first housing 210, the second housing 220, the hinge assembly 230, and the flexible display 250 of FIGS. 2 and 3.

According to an embodiment, the electronic device 101 may include various electronic components (or electrical components) disposed inside or outside the first housing 210 and the second housing 220. The various electronic components may include, e.g., a processor (e.g., the processor 120 of FIG. 1), a memory (e.g., the memory 130 of FIG. 1), an input module (e.g., the input module 150 of FIG. 1), a sound output module (e.g., sound output module 155 of FIG. 1), a display 250 (e.g., the display module 160 of FIG. 1), an audio module (e.g., the audio module 170 of FIG. 1), a sensor (e.g., the sensor module 176 of FIG. 1), an interface (e.g., the interface 177 of FIG. 1), a connecting terminal (e.g., the connecting terminal 178 of FIG. 1 or the connecting terminal 289 of FIG. 2), a haptic module (e.g., the haptic module 179 of FIG. 1), a camera module (e.g., the camera module 180 of FIG. 1), a power management module (e.g., the power management module 188 of FIG. 1), batteries 271 and 272 (e.g., the battery 189 of FIG. 1), a communication module (e.g., the communication module 190 of FIG. 1), a subscriber identification module (e.g., the subscriber identification module 196 of FIG. 1), or an antenna module (e.g., the antenna module 197 of FIG. 1). The electronic components may be appropriately separated and disposed in the inner or outer space of the first housing 210 and the second housing 220. At least one (e.g., the connecting terminal 178) of the components may be omitted from the electronic device 101, or one or more other components may be added in the electronic device 101. Further, some of these components may be integrated into one component.

According to an embodiment, the electronic device 101 is a foldable electronic device, and may include a plurality of batteries to supply and store power required for driving to electronic components. For example, the electronic device 101 may include a first battery 271 and a second battery 272 disposed in the first housing 210 and the second housing 220, respectively.

According to an embodiment, the first housing 210 may include a 1-1th side surface 211a (e.g., the 1-1th side surface 211a of FIGS. 2 to 3), a 1-2th side surface 211b (e.g., the 1-2th side surface 211b of FIGS. 2 to 3), a 1-3th side surface 211c (e.g., the 1-3th side surface 211c of FIGS. 2 to 3), and/or a first plate 213.

According to an embodiment, the second housing 220 may include a 2-1th side surface 221a (e.g., the 2-1th side surface 221a of FIGS. 2 to 3), a 2-2th side surface 221b (e.g., the 2-2th side surface 221b of FIGS. 2 to 3), a 2-3th side surface 221c (e.g., the 2-3th side surface 221c of FIGS. 2 to 3), and/or a second plate 223.

According to an embodiment, the electronic device 101 is a foldable electronic device, and may include a first plate 213 and/or a second plate 223 for disposing components in the first housing 210 and the second housing 220. In an embodiment, the first plate 213 may be interpreted as a component of the first housing 210, and the second plate 223 may be interpreted as a component of the second housing 220. In an embodiment, the first plate 213 may be interpreted as a separate component from the first housing 210, and the second plate 223 may be interpreted as a separate component from the second housing 220. Various electronic components and/or printed circuit boards 241 and 242 may be disposed on the first plate 213 and/or the second plate 223. According to an embodiment, the first plate 213 and the first printed circuit board 241 may be disposed in the first housing 210, and the second plate 223 and the second printed circuit board 242 may be disposed in the second housing 220. The first plate 213 may include a first surface facing in a first direction (e.g., the +Z direction of FIG. 4), and the second plate 223 may include a second surface facing in a second direction (e.g., the -Z direction of FIG. 4). The first plate 213 and the second plate 223 may be folded or unfolded with respect to each other by the hinge structure 231 formed corresponding to the folding area 253 of the flexible display 250 and be formed to face each other in the folded state and, in the unfolded state, be formed so that the first surface and the second surface face in the same direction.

According to an embodiment, the first printed circuit board 241 may be disposed in the first waterproof area 261-1 formed by the first waterproof member 261.

According to an embodiment, the flexible display 250 may be disposed in the first housing 210 and the second housing 220. According to an embodiment, the first display area 251 may be disposed on the first housing 210 (or the first plate 213), and the second display area 252 may be disposed on the second housing 220 (or the second plate 223). According to an embodiment, the folding area 253 may connect the first display area 251 and the second display area 252 and may be disposed on the hinge structure 231.

According to an embodiment, the first printed circuit board 241 may be disposed under the first plate 213 (in the -Z-axis direction), and the second printed circuit board 242 may be disposed under the second plate 223 (in the -Z-axis direction).

According to an embodiment, signals of the processor for implementing various functions and operations of the electronic device 101 may be transferred through various conductive lines and/or connecting member (connector) formed on the printed circuit boards 241 and 242.

According to an embodiment, the foldable housing 201 may include a first housing 210, a second housing 220, a first rear cover 215, a second rear cover 225, and a hinge assembly 230.

According to an embodiment, the flexible display 250 may include a display panel. In an embodiment, the first plate 213 and the second plate 223 may be disposed between the display panel and the first printed circuit board 241 and the second printed circuit board 242. The hinge assembly 230 may be disposed between the first plate 213 and the second plate 223.

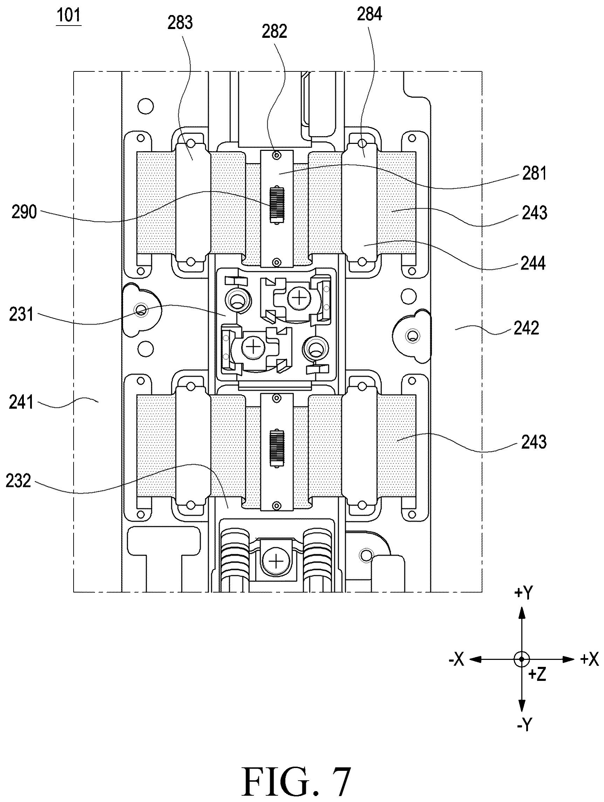

According to an embodiment, the electronic device 101 may include a flexible printed circuit board 243 (FPCB) that electrically connects the first printed circuit board 241 and the second printed circuit board 242. At least a portion of the flexible printed circuit board 243 may be disposed on the hinge assembly 230 (or the hinge structure 231). At least one electromagnet (e.g., the electromagnet 290 of FIG. 7) configured to provide a magnetic force to a digital pen (e.g., the digital pen 300 of FIGS. 5 to 6) may be disposed on the flexible printed circuit board 243.

According to an embodiment, the electronic device 101 may further include a sub display 218 (e.g., the display module 160 of FIG. 1) disposed between the first housing 210 and the first rear cover 215. According to an embodiment, the sub display 218 may include a display panel. According to an embodiment, the sub display 218 may be coupled to the first rear cover 215. According to an embodiment, the sub display 218 may be coupled to the first printed circuit board 241. For example, the sub display 218 may be visually exposed to the outside of the electronic device 101 through a first rear area (e.g., the first rear area 216 of FIG. 2) of the first rear cover 215.

According to an embodiment, the hinge assembly 230 may include a hinge structure 231 and a hinge cover 232. According to an embodiment, the first housing 210 and the second housing 220 may be connected to each other through the hinge structure 231, and may rotate relative to each other. According to an embodiment, the hinge cover 232 may cover the hinge structure 231.

According to an embodiment, it may connect the first housing 210 and the second housing 220 to be rotatable relative to each other.

According to an embodiment, the electronic device 101 may include a first printed circuit board 241 and a second printed circuit board 242. The first printed circuit board 241 and the second printed circuit board 242 may be disposed in a space formed by the first plate 1241, the second plate 223, the first housing 210, the second housing 220, the first rear cover 215, and the second rear cover 225. Components for implementing various functions of the electronic device 101 may be disposed on the first printed circuit board 241 and the second printed circuit board 242. According to an embodiment, each of the first printed circuit board 241 and the second printed circuit board 242 may include any one of a printed circuit board (PCB), a flexible printed circuit board (PCB), or a rigid-flexible PCB (RF-PCB).

According to an embodiment, the first housing 210 and the second housing 220 may be assembled to be coupled to two opposite sides of the hinge assembly 230 in a state in which the first plate 213 and the second plate 223 and the flexible display 250 are coupled. For example, the first housing 210 may be coupled by sliding on one side of the hinge assembly 230, and the second housing 220 may be coupled by sliding on the other side of the hinge assembly 230.

According to an embodiment, the waterproof member 260 may be disposed inside the electronic device 101. According to an embodiment, the waterproof member 260 may include a first waterproof member 261, a second waterproof member 262, a third waterproof member 263, and/or a fourth waterproof member 264.

According to an embodiment, the first waterproof member 261 may be disposed between the first housing 210 and the flexible display 250. According to an embodiment, the first waterproof member 261 may be disposed between the first plate 213 and the first display area 251. According to an embodiment, the first waterproof member 261 may be formed of a waterproof tape. According to an embodiment, the first waterproof member 261 may be bonded to the first housing 210 and/or the first plate 213, and may be bonded to the flexible display 250 (e.g., the first display area 251). According to an embodiment, the first waterproof member 261 may have a closed loop shape. For example, the first waterproof member 261 may include at least one closed loop area. According to an embodiment, the first waterproof member 261 may include a waterproof tape, and may restrict liquid inflow from the outside of the closed loop area of the first waterproof member 261 to the inside of the closed loop area.

According to an embodiment, the first waterproof member 261 may include at least one first waterproof area 261-1. According to an embodiment, the at least one first waterproof area 261-1 may be defined and interpreted as an inside of the closed loop area of the first waterproof member 261.

According to an embodiment, the second waterproof member 262 may be disposed between the second housing 220 and the flexible display 250. According to an embodiment, the second waterproof member 262 may be disposed between the second plate 223 and the second display area 252. According to an embodiment, the second waterproof member 262 may be formed of a waterproof tape. According to an embodiment, the second waterproof member 262 may be bonded to the second housing 220 and/or the second plate 223, and may be bonded to the flexible display 250 (e.g., the second display area 252). According to an embodiment, the second waterproof member 262 may have a closed loop shape. For example, the second waterproof member 262 may include at least one closed loop area. According to an embodiment, the second waterproof member 262 may include a waterproof tape, and may restrict liquid inflow from the outside of the closed loop area of the second waterproof member 262 to the inside of the closed loop area.

According to an embodiment, the second waterproof member 262 may include at least one second waterproof area 262-1. According to an embodiment, the at least one second waterproof area 262-1 may be defined and interpreted as the inside of a closed loop area of the second waterproof member 262.

According to an embodiment, the third waterproof member 263 may be disposed between the first housing 210 and the first rear cover 215. According to an embodiment, the third waterproof member 263 may be disposed between the first plate 213 and the sub display 218. According to an embodiment, the third waterproof member 263 may be formed of a waterproof tape. According to an embodiment, the third waterproof member 263 may be bonded to the first housing 210 and/or the first plate 213, and may be bonded to the first rear cover 215 and/or the sub display 218. According to an embodiment, the third waterproof member 263 may have a closed loop shape. For example, the third waterproof member 263 may include at least one closed loop area. According to an embodiment, the third waterproof member 263 may include a waterproof tape, and may restrict liquid inflow from the outside of the closed loop area of the third waterproof member 263 to the inside of the closed loop area.

According to an embodiment, the third waterproof member 263 may include at least one third waterproof area 263-1. According to an embodiment, the at least one third waterproof area 263-1 may be defined and interpreted as an inside of the closed loop area of the third waterproof member 263.

According to an embodiment, the fourth waterproof member 264 may be disposed between the second housing 220 and the second rear cover 225. According to an embodiment, the fourth waterproof member 264 may be disposed between the second plate 223 and the second rear cover 225. According to an embodiment, the fourth waterproof member 264 may be formed of a waterproof tape. According to an embodiment, the fourth waterproof member 264 may be bonded to the second housing 220 and/or the second plate 223, and may be bonded to the second rear cover 225. According to an embodiment, the fourth waterproof member 264 may have a closed loop shape. For example, the fourth waterproof member 264 may include at least one closed loop area. According to an embodiment, the fourth waterproof member 264 may include a waterproof tape, and may restrict liquid inflow from the outside of the closed loop area of the fourth waterproof member 264 to the inside of the closed loop area.

According to an embodiment, the fourth waterproof member 264 may include at least one fourth waterproof area 264-1. According to an embodiment, the at least one fourth waterproof area 264-1 may be defined and interpreted as an inside of the closed loop area of the fourth waterproof member 264.

According to an embodiment, the first waterproof member 261, the second waterproof member 262, the third waterproof member 263, and the fourth waterproof member 264 may be disposed not to contact the hinge assembly 230.

According to an embodiment, as the waterproof member 260 is disposed inside the electronic device 101, the electronic device 101 may restrict the inflow of liquid from the outside of the electronic device 101 into the electronic device 101.

FIG. 5 is an exploded perspective view illustrating a digital pen according to an embodiment of the disclosure.

FIG. 6 is a block diagram illustrating a digital pen according to an embodiment of the disclosure.

The embodiments of FIGS. 5 and 6 may be combinable with the embodiments of FIGS. 1 to 4, or the embodiments of FIGS. 7 to 26.

Referring to FIGS. 5 to 6, the electronic device (e.g., the electronic device 101 of FIGS. 1 to 4) may include a digital pen 300. The digital pen 300 may be defined and/or interpreted as a component of the electronic device but, without limitations thereto, may be defined and/or interpreted as a separate component from the electronic device.

The configuration of the digital pen 300 of FIGS. 5 to 6 may be identical in whole or part to the configuration of the electronic device 101 or the input module 150 of FIG. 1.

According to an embodiment, the digital pen 300 may include a separate resonance circuit (e.g., the resonance circuit 487 of FIG. 6) built-in and may be linked with an electromagnetic induction panel (e.g., digitizer) of the electronic device 101. For example, the digital pen 300 may include an electro-magnetic resonance (EMR) method, an active electrical stylus (AES), or an electric coupled resonance (ECR) method.

According to an embodiment, the digital pen 300 may include a button portion 313 (e.g., the button portion 313 of FIG. 5) disposed at one end to facilitate removal of the digital pen 300 from the accommodation space of the electronic device 101. For example, when the button portion 313 is pressed by a user, a repulsion mechanism (e.g., at least one spring) associated with the button portion 313 operates, and the digital pen 300 may be released from the accommodation space of the electronic device 101.

According to an embodiment, the digital pen 300 may enable a handwriting input to the electronic device 101. For example, the digital pen 300 may provide various input functions in conjunction with an electromagnetic induction panel (e.g., digitizer).

Referring to FIG. 5, the digital pen 300 may include a pen housing 301 forming the exterior of the digital pen 300 and an inner assembly inside the pen housing 301. According to an embodiment, the inner assembly may include all various components disposed inside the pen and may be inserted into the pen housing 301 in a single assembly operation.

According to an embodiment, the pen housing 301 may have an elongated shape between a first end 301a and a second end 301b and may include an accommodation space 302 inside. The pen housing 301 may have an elliptical cross-section with a major axis and a minor axis, and may be formed in the shape of an elliptical cylinder overall. According to an embodiment, the cross-sectional shape of the pen housing 301 may be formed in various shapes such as circular or polygonal. The pen housing 301 may include a synthetic resin (e.g., plastic) and/or a metallic material (e.g., aluminum). According to an embodiment, the second end 301b of the pen housing 301 may be formed of a synthetic resin material.

According to an embodiment, the inner assembly may have an elongated shape corresponding to the shape of the pen housing 301. The inner assembly may largely be divided into three components along the lengthwise direction. For example, the inner assembly may include an ejection member 310 disposed at a position corresponding to the first end 301a of the pen housing 301, a coil portion 320 disposed at a position corresponding to the second end 301b of the pen housing 301, a circuit board portion 330 disposed at a position corresponding to the body of the pen housing 301, and at least one magnetic member 340.

According to an embodiment, the ejection member 310 may include a configuration for removing the digital pen 300 from the accommodation space 228 of the electronic device 101. According to an embodiment, the ejection member 310 may include a shaft 311, an ejection body 312 disposed around the shaft 311 and forming the overall exterior of the ejection member 310, and a button portion 313. When the inner assembly is fully inserted into the pen housing 301, the portion including the shaft 311 and the ejection body 312 is surrounded by the first end 301a of the pen housing 301, and the button portion 313 (e.g., the button portion 313 of FIG. 5) may be exposed to the outside of the first end 301a. A plurality of components not illustrated, e.g., cam members or elastic members, may be disposed in the ejection body 312 to form a push-pull structure. According to an embodiment, the button portion 313 may be substantially coupled with the shaft 311 to perform linear reciprocating motion with respect to the ejection body 312. According to an embodiment, the button portion 313 may include a button with a catching structure formed so that a user may pull out the digital pen 300 using a fingernail. According to an embodiment, the digital pen 300 may include a sensor to detect the linear motion of the shaft 311 to thereby provide another input scheme.

According to an embodiment, the coil portion 320 may include a pen tip 321 exposed to the outside of the second end 301b when the inner assembly is fully inserted into the pen housing 301, a packing ring 322, a coil 323 wound multiple times, or a pressure sensing portion 324 for obtaining a change in pressure according to pressing of the pen tip 321. The packing ring 322 may include epoxy, rubber, urethane, or silicone. The packing ring 322 may be provided for waterproof or dustproof purposes and protect the coil portion 320 and the circuit board portion 330 from water or dust. According to an embodiment, the coil 323 may form a resonance frequency within a preset frequency band (e.g., 500kHz) and may be combined with at least one device (e.g., a capacitor) to adjust the resonance frequency produced by the coil 323 within a predetermined range.

According to an embodiment, the circuit board portion 330 may include a printed circuit board 332, a base 331 surrounding at least one surface of the printed circuit board 332, or an antenna. According to an embodiment, a board seating portion 333 where the printed circuit board 332 is disposed may be formed on the upper surface of the base 331, and the printed circuit board 332 may be fixed while seated in the board seating portion 333. According to an embodiment, the printed circuit board 332 may include a top surface and a bottom surface. A variable capacitor or a switch 334 may be disposed on the top surface of the printed circuit board 332, and a charging circuit, a battery, or a communication circuit may be disposed on the bottom surface of the printed circuit board 332. The battery may include an electric double layered capacitor (EDLC). The charging circuit is positioned between the coil 323 and the battery and may include voltage detector circuitry or a rectifier.

According to an embodiment, the antenna may include an antenna structure and/or an antenna embedded in the printed circuit board 332. According to embodiments, a switch 334 may be provided on the printed circuit board 332. A side button 337 provided to the digital pen 300 may be used to press the switch 334 and may be exposed to the outside through a side opening 303 of the pen housing 301. The side button 337 may be supported by the supporting member 338 and, if no external force is applied to the side button 337, the supporting member 338 may provide an elastic restoration force to allow the side button 337 to remain or go back to a predetermined position.

According to an embodiment, the circuit board portion 330 may include another packing ring such as an O-ring. For example, an O-ring formed of an elastic material may be disposed at two opposite ends of the base 331 to form a sealing structure between the base 331 and the pen housing 301. According to an embodiment, the supporting member 338 may partially adhere to the inner wall of the pen housing 301 around the side opening 303 to form a sealing structure. For example, the circuit board portion 330 may also form a waterproof and dustproof structure similar to the packing ring 322 of the coil portion 320.

According to an embodiment, the digital pen 300 may include a battery seating portion 335 where a battery 336 is disposed on the upper surface of the base 331. The battery 336 that may be mounted in the battery seating portion 335 may include, e.g., a cylinder type battery.

According to an embodiment, the digital pen 300 may include at least one magnetic member 340 disposed inside the pen housing 301. The at least one magnetic member 340 may be provided as a pair spaced apart from each other but, without limitations thereto, may be provided as one magnetic member 340 or may be provided as three or more magnetic members 340.

According to an embodiment, the at least one magnetic member 340 may include a permanent magnet or a Halbach array magnet. The at least one magnetic member 340 may allow the digital pen 300 to be fixed to at least a portion of the electronic device 101 based on the magnetic force provided from the electromagnet (e.g., the electromagnet 290 of FIG. 7) of the electronic device 101.

According to an embodiment, the digital pen 300 may include a microphone. The microphone may be directly connected to the printed circuit board 332 or may be connected to a separate flexible printed circuit board (FPCB) connected to the printed circuit board 332. According to an embodiment, the microphone may be disposed at a position parallel to the side button 337 in the length direction of the digital pen 300.

Referring to FIG. 6, according to an embodiment, the digital pen 300 may include a processor 420, a memory 430, a resonance circuit 487, a charging circuit 488, a battery 489, a communication circuit 490, an antenna 497, and/or a trigger circuit 498. In an embodiment, the processor 420 of the digital pen 300, at least a portion of the resonance circuit 487, and/or at least a portion of the communication circuit 490 may be configured on the printed circuit board (e.g., the printed circuit board 332 of FIG. 6) or in chip form. The processor 420, the resonance circuit 487, and/or the communication circuit 490 may be electrically connected with the memory 430, the charging circuit 488, the battery 489, the antenna 497, or the trigger circuit 498. According to an embodiment, the digital pen 300 may be configured only of a resonance circuit and a button.

According to an embodiment, the processor 420 may include a customized hardware module or a generic processor configured to execute software (e.g., an application program). The processor may include a hardware component (function) or software element (program) including at least one of a communication module or a module to manage the state or environment of the digital pen 300, an input/output interface, a data measuring module, and various sensors provided in the digital pen 300. The processor 420 may include, e.g., a hardware module, a software module, a firmware module, or a combination of two or more thereof. According to an embodiment, the processor 420 may receive a proximity signal corresponding to an electromagnetic field signal generated from the digitizer 160 of the electronic device 101 through the resonance circuit 487. When the proximate signal is identified, the processor 420 may control the resonance circuit 487 to transmit an electromagnetic resonance (EMR) input signal to the electronic device 101.

According to an embodiment, the memory 430 may store information related to the operation of the digital pen 300. For example, the information may include information for communication with the electronic device 101 and frequency information related to the input operation of the digital pen 300.

According to an embodiment, the resonance circuit 487 may include at least one of a coil, an inductor, or a capacitor. The resonance circuit 487 may be used for the digital pen 300 to generate a signal having a resonance frequency. For example, to generate the signal, the digital pen 300 may use at least one of an electro-magnetic resonance (EMR) scheme, an active electrostatic (AES) scheme, or an electrically coupled resonance (ECR) scheme. When the digital pen 300 transmits signals via the EMR scheme, the digital pen 300 may generate a signal having a resonance frequency based on an electromagnetic field generated from the inductive panel of the electronic device 101. When the digital pen 300 transmits signals via the AES scheme, the digital pen 300 may generate a signal using a capacitive coupling with the electronic device 101. When the digital pen 300 transmits signals via the ECR scheme, the digital pen 300 may generate a signal having a resonance frequency based on an electric field generated from a capacitive device of the electronic device. According to an embodiment, the resonance circuit 487 may be used to vary the frequency or strength of electromagnetic field according to the user's manipulation state. For example, the resonance circuit 487 may provide a frequency to recognize a hovering input, drawing input, button input, or erasing input.

According to an embodiment, when connected with the resonance circuit 487 based on a switching circuit, the charging circuit 488 may rectify a resonance signal generated from the resonance circuit 487 into a direct current (DC) signal and provide the DC signal to the battery 489. According to an embodiment, the digital pen 300 may identify whether the digital pen 300 is inserted into the electronic device 101 using a voltage level of a DC signal sensed by the charging circuit 488.

According to an embodiment, the battery 489 may be configured to store power required to operate the digital pen 300. The battery may include, e.g., a lithium-ion battery or a capacitor and may be recharged or replaced. According to an embodiment, the battery 489 may be charged with power (e.g., DC signal (DC power)) received from the charging circuit 488.

According to an embodiment, the communication circuit 490 may be configured to perform wireless communication between the digital pen 300 and the communication module 190 of the electronic device 101. According to an embodiment, the communication circuit 490 may transmit input information and state information about the digital pen 300 to the electronic device 101 using a short-range communication scheme. For example, the communication circuit 490 may transmit direction information (e.g., motion sensor data) about the digital pen 300 obtained through the trigger circuit 498, voice information entered through the microphone, or remaining power information about the battery 489 to the electronic device 101. As an example, the short-range communication scheme may include at least one of Bluetooth low energy (BLE) or wireless local area network (WLAN).

According to an embodiment, the antenna 497 may be used to transmit signals or power to the outside (e.g., the electronic device 101) or receive signals or power from the outside. According to an embodiment, the digital pen 300 may include a plurality of antennas 497 and select at least one antenna 497 appropriate for the communication scheme from among the plurality of antennas. The communication circuit 490 may exchange signals or power with an external electronic device through the at least one selected antenna 497.

According to an embodiment, the trigger circuit 498 may include at least one button or sensor circuit. According to an embodiment, the processor 420 may identify the input scheme (e.g., touch or press) or kind (e.g., EMR button or BLE button) of the button of the digital pen 300. According to an embodiment, the sensor circuit may generate an electrical signal or data value corresponding to an internal operating state or external environmental state of the digital pen 300. For example, the sensor circuit may include at least one of a motion sensor, a remaining battery sensor, a pressure sensor, a light sensor, a temperature sensor, a geomagnetic sensor, or a biometric sensor. According to an embodiment, the trigger circuit 498 may transmit a trigger signal to the electronic device 101 using a signal through a sensor or a button input signal.

FIG. 7 is a view illustrating a flexible printed circuit board and at least one electromagnet of an electronic device according to an embodiment of the disclosure.

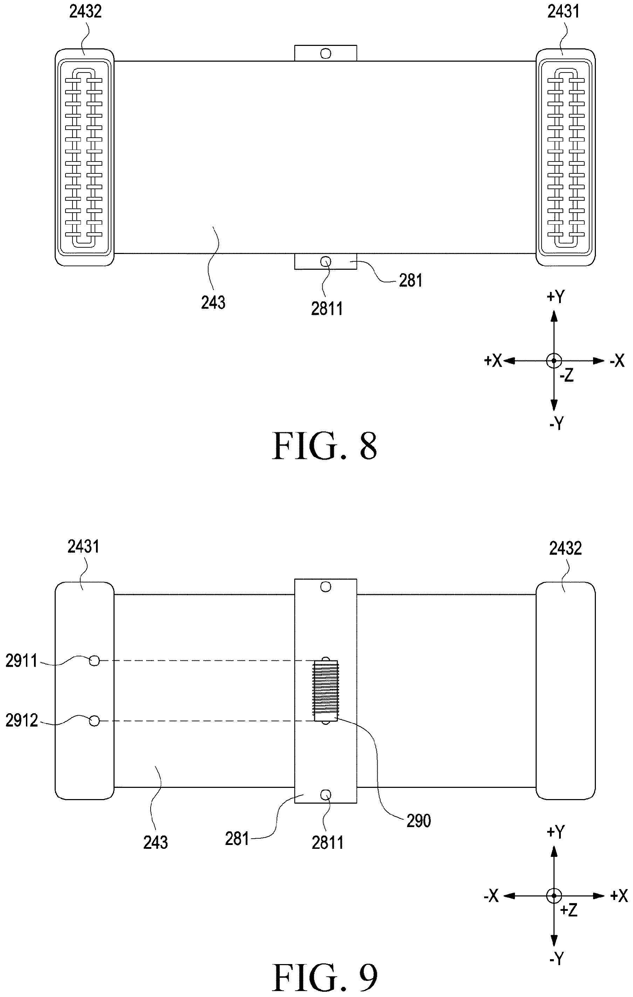

FIG. 8 is a plan view illustrating a flexible printed circuit board of an electronic device according to an embodiment of the disclosure.

FIG. 9 is a plan view illustrating a flexible printed circuit board of an electronic device according to an embodiment of the disclosure.

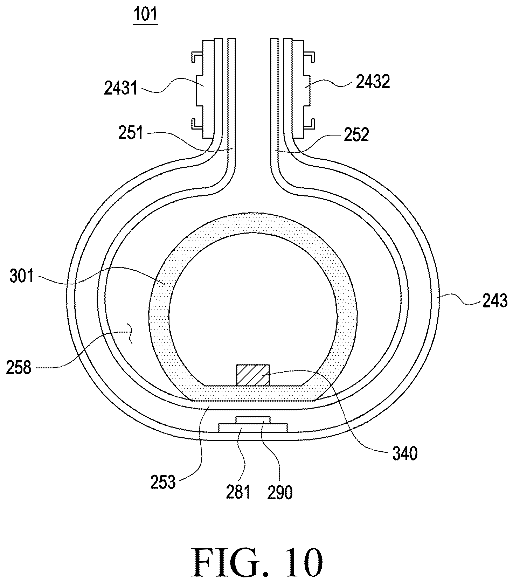

FIG. 10 is a schematic view illustrating an electronic device and a digital pen according to an embodiment of the disclosure.

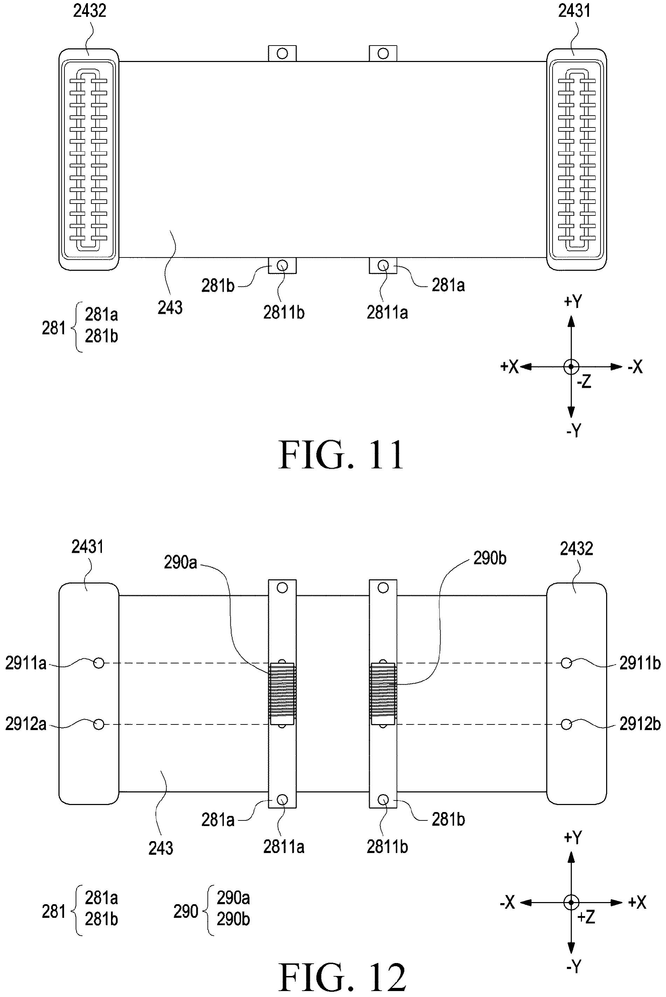

The embodiments of FIGS. 7 to 10 may be combined with the embodiments of FIGS. 1 to 6 or the embodiments of FIGS. 11 to 26.

Referring to FIGS. 7 to 10, the electronic device 101 (e.g., the electronic device 101 of FIGS. 1 to 4) may include a hinge structure 231, a hinge cover 232, a first printed circuit board 241, a second printed circuit board 242, a flexible printed circuit board 243, at least one reinforcing member 281, 283, 284, or at least one electromagnet 290.

The configuration of the hinge structure 231, the hinge cover 232, the first printed circuit board 241, the second printed circuit board 242, or the flexible printed circuit board 243 of FIG. 7 may be identical in whole or part to the configuration of the hinge structure 231, the hinge cover 232, the first printed circuit board 241, the second printed circuit board 242, or the flexible printed circuit board 243 of FIG. 4.

According to an embodiment, the flexible printed circuit board 243 may be electrically connected to the first printed circuit board 241 and the second printed circuit board 242. For example, the flexible printed circuit board 243 may be electrically connected to the first printed circuit board 241 disposed inside the first housing (e.g., the first housing 210 of FIG. 4). The flexible printed circuit board 243 may be electrically connected to the second printed circuit board 242 disposed inside the second housing (e.g., the second housing 220 of FIG. 4).

According to an embodiment, the flexible printed circuit board 243 may include a first connector (e.g., the first connector 2431 of FIGS. 8 to 10) or a second connector (e.g., the second connector 2432 of FIGS. 8 to 10). The first connector 2431 of the flexible printed circuit board 243 may be electrically connected to the connector of the first printed circuit board 241, and the second connector 2432 of the flexible printed circuit board 243 may be electrically connected to the connector of the second printed circuit board 242.

According to an embodiment, at least a portion of the flexible printed circuit board 243 may be disposed on the hinge structure 231 (or the hinge cover 232).

According to an embodiment, the flexible printed circuit board 243 may extend from the inside of the first housing (e.g., the first housing 210 of FIG. 4) to the inside of the second housing (e.g., the second housing 220 of FIG. 4). For example, at least a portion of the flexible printed circuit board 243 may be disposed to cross the hinge structure 231.

According to an embodiment, at least a portion of the flexible printed circuit board 243 may be disposed between the folding area (e.g., the folding area 253 of FIG. 4) of the flexible display (e.g., the flexible display 250 of FIG. 4) and the hinge structure 231.

According to an embodiment, the flexible printed circuit board 243 may be at least partially bent or unfolded according to the internal structure of the electronic device 101 or the state change of the electronic device 101. For example, when the electronic device 101 changes from an unfolded state (e.g., FIG. 2) to a folded state (e.g., FIG. 3) or when the electronic device 101 changes from a folded state (e.g., FIG. 3) to an unfolded state (e.g., FIG. 2), the flexible printed circuit board 243 may be at least partially bent or unfolded according to the relative rotational movement of the first housing (e.g., the first housing 210 of FIG. 4) and the second housing (e.g., the second housing 220 of FIG. 4).

According to an embodiment, the electronic device 101 may further include at least one reinforcing member 281, 283, 284. The at least one reinforcing member 281, 283, 284 may be configured to at least partially limit the movement of the flexible printed circuit board 243.

According to an embodiment, the at least one reinforcing member 281, 283, 284 may include a first reinforcing member 281, a second reinforcing member 283, or a third reinforcing member 284.

According to an embodiment, at least a portion of the first reinforcing member 281 may be fixed to the hinge structure 231 (or the hinge cover 232). For example, the first reinforcing member 281 may be coupled to the hinge structure 231 through a fastening member 282 (e.g., bolt or pin). The fastening member 282 may be inserted into a pair of holes 2811 formed at positions adjacent to two opposite ends of the first reinforcing member 281, respectively. At least a portion of the flexible printed circuit board 243 may be disposed between the hinge structure 231 (or the hinge cover 232) and the first reinforcing member 281. The first reinforcing member 281 may limit the movement or flow of the flexible printed circuit board 243 when the flexible printed circuit board 243 is bent or unfolded according to the state change of the electronic device 101.

According to an embodiment, at least a portion of the second reinforcing member 283 may be fixed to the first printed circuit board 241. For example, the second reinforcing member 283 may be coupled to the first printed circuit board 241 through a fastening member (e.g., bolt or pin). A partial area of the flexible printed circuit board 243 may be disposed between the first printed circuit board 241 and the second reinforcing member 283. The second reinforcing member 283 may limit the movement or flow of the flexible printed circuit board 243 when the flexible printed circuit board 243 is bent or unfolded according to the state change of the electronic device 101.

According to an embodiment, at least a portion of the third reinforcing member 284 may be fixed to the second printed circuit board 242. For example, the third reinforcing member 284 may be coupled to the second printed circuit board 242 through a fastening member (e.g., bolt or pin). A partial area of the flexible printed circuit board 243 may be disposed between the second printed circuit board 242 and the third reinforcing member 284. The third reinforcing member 284 may limit the movement or flow of the flexible printed circuit board 243 when the flexible printed circuit board 243 is bent or unfolded according to the state change of the electronic device 101.

According to an embodiment, at least one electromagnet 290 may be disposed on the flexible printed circuit board 243. For example, at least one electromagnet 290 may be disposed between the flexible printed circuit board 243 and the folding area (e.g., the folding area 253 of FIG. 4 or FIG. 10) of the display (e.g., the display 250 of FIG. 4). At least one electromagnet 290 may be disposed or positioned on at least a partial area of the flexible printed circuit board 243 disposed on the hinge structure 231 (or the hinge cover 232). For example, at least one electromagnet 290 may be disposed or positioned on at least a partial area of the flexible printed circuit board 243 disposed on the hinge assembly (e.g., the hinge assembly 230 of FIGS. 2 to 4).

According to an embodiment, at least one electromagnet 290 may be disposed on the first reinforcing member 281. For example, at least one electromagnet 290 may be fixed to the first reinforcing member 281.

According to an embodiment, at least one electromagnet 290 may also be directly disposed on at least a portion of the flexible printed circuit board 243.

The at least one electromagnet 290 may be applied with current provided from the first battery (e.g., the first battery 271 of FIG. 4) disposed inside the first housing (e.g., the first housing 210 of FIG. 4). For example, at least one electromagnet 290 may be applied with current from the first battery through a conductive line included in the flexible printed circuit board 243. For example, a pair of power supply portions 2911, 2912 included in the first connector 2431 may be electrically connected to the first printed circuit board 241, and current provided from the first battery 271 may be provided to at least one electromagnet 290 through the first printed circuit board 241 and the pair of power supply portions 2911, 2912. According to an embodiment, the at least one electromagnet 290 may be applied with current from the second battery (e.g., the second battery 272 of FIG. 4) disposed inside the second housing (e.g., the second housing 220 of FIG. 4).

According to an embodiment, at least one electromagnet 290 may generate magnetic force when current is applied and may not generate magnetic force when current is not applied (e.g., when current is cut off). The at least one electromagnet 290 may provide magnetic force to at least one magnetic member (e.g., the at least one magnetic member 340 of FIG. 5 or FIG. 10) of the digital pen (e.g., the digital pen 300 of FIGS. 5 to 6). The attractive force formed between the at least one electromagnet 290 and the at least one magnetic member 340 may fix the digital pen (e.g., the digital pen 300 of FIGS. 5 to 6) to at least a portion of the electronic device 101.

FIG. 10 illustrates the electronic device 101 in a folded state (e.g., FIG. 3). Referring to FIG. 10, the electronic device 101 may include a flexible display (e.g., the flexible display 250 of FIG. 4) including a first display area 251 (e.g., the first display area 251 of FIG. 4), a second display area 252 (e.g., the second display area 252 of FIG. 4), and a folding area 253 (e.g., the folding area 253 of FIG. 4).

According to an embodiment, the folding area 253 may form an accommodation space 258 capable of accommodating a digital pen (e.g., the digital pen 300 of FIG. 5) including at least one magnetic member 340 (e.g., the at least one magnetic member 340 of FIG. 5) when the electronic device 101 is in a folded state (e.g., FIG. 3) (or when the housing (e.g., the housing 201 of FIG. 3) is in a folded state). According to an embodiment, the folding area 253 may define at least a portion of the accommodation space 258 capable of accommodating the digital pen when the electronic device 101 is in a folded state.

According to an embodiment, the pen housing 301 (e.g., the pen housing 301 of FIG. 5) of the digital pen may be positioned in the accommodation space 258. For example, a user may store the digital pen in the accommodation space 258 when the electronic device 101 is in a folded state.

According to an embodiment, at least one magnetic member 340 disposed inside the pen housing 301 may form an attractive force with the at least one electromagnet 290. According to an embodiment, the attractive force may fix the pen housing 301 to the folding area 253. Accordingly, in the process of using the electronic device 101, the release of the digital pen from the accommodation space 258 defined by the folding area 253 is decreased or limited, thereby enhancing the usability of the electronic device 101 and the digital pen.

According to an embodiment, when the digital pen is accommodated in the accommodation space 258, at least a portion of the folding area 253 may be positioned between the at least one magnetic member 340 and the at least one electromagnet 290. The flexible display 250 may include an electromagnetic induction panel (e.g., digitizer). The electromagnetic induction panel may be provided integrally with the flexible display or may be provided by being stacked on one surface (e.g., a surface facing the inside of the electronic device 101) of the flexible display. When the digital pen is accommodated in the accommodation space 258, at least a portion of the electromagnetic induction panel of the flexible display (e.g., the flexible display 250 of FIG. 4) may be positioned between the at least one magnetic member 340 and the at least one electromagnet 290.

FIG. 11 is a plan view illustrating a flexible printed circuit board of an electronic device according to an embodiment of the disclosure.

FIG. 12 is a plan view illustrating a flexible printed circuit board of an electronic device according to an embodiment of the disclosure.

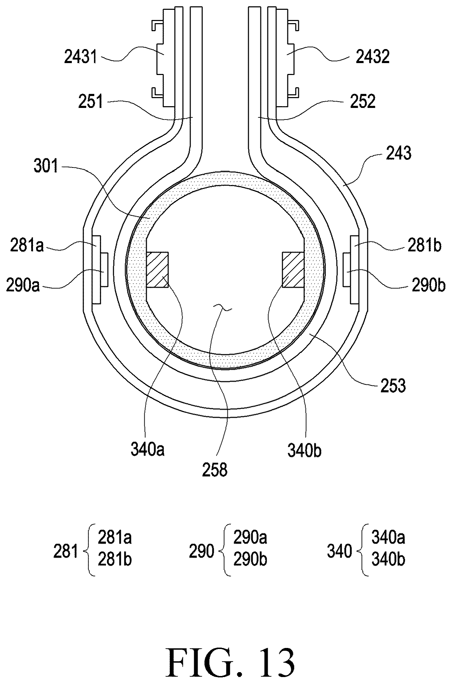

FIG. 13 is a schematic view illustrating an electronic device and a digital pen according to an embodiment of the disclosure.

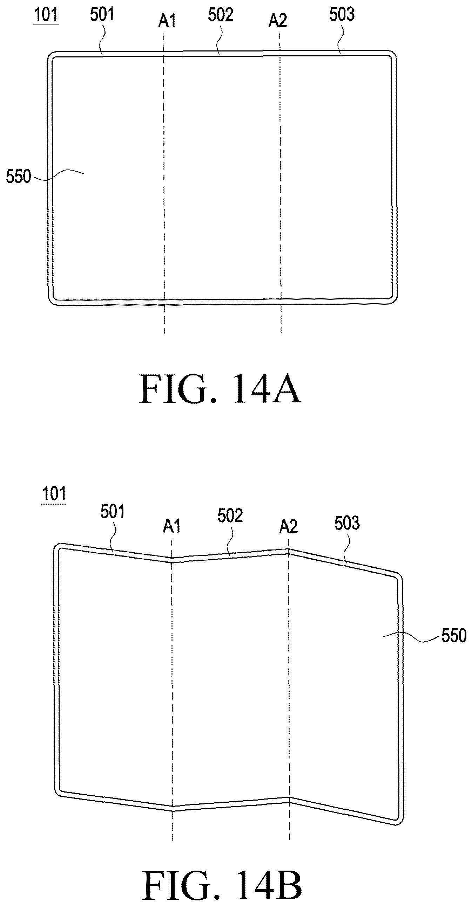

The embodiments of FIGS. 11 to 13 may be combined with the embodiments of FIGS. 1 to 10 or the embodiments of FIGS. 14A to 26.

Referring to FIGS. 11 to 13, the electronic device 101 (e.g., the electronic device 101 of FIGS. 1 to 4) may include a flexible printed circuit board 243, a flexible display (e.g., the flexible display 250 of FIG. 4), at least one first reinforcing member 281, or at least one electromagnet 290. The flexible printed circuit board 243 may include a first connector 2431 or a second connector 2432.

The configuration of the flexible printed circuit board 243, the at least one first reinforcing member 281, or the at least one electromagnet 290 of FIGS. 11 to 13 may be identical in whole or part to the configuration of the flexible printed circuit board 243, the at least one first reinforcing member 281, or the at least one electromagnet 290 of FIGS. 7 to 10. The configuration of the first connector 2431 or the second connector 2432 of FIGS. 11 to 13 may be identical in whole or part to the configuration of the first connector 2431 or the second connector 2432 of FIGS. 7 to 10.

According to an embodiment, at least one first reinforcing member 281a, 281b may be configured to at least partially limit the movement of the flexible printed circuit board 243.

According to an embodiment, at least one first reinforcing member 281 may include a 1-1th reinforcing member 281a or a 1-2th reinforcing member 281b spaced apart from each other. The 1-1th reinforcing member 281a and/or the 1-2th reinforcing member 281b may be defined and/or referred to as a first reinforcing member 281a and/or a 1-2th reinforcing member 281b.

According to an embodiment, at least a portion of the 1-1th reinforcing member 281a may be fixed to the hinge structure 231 (or the hinge cover 232). For example, the 1-1th reinforcing member 281a may be coupled to the hinge structure 231 through a fastening member (e.g., bolt or pin). The fastening member may be inserted into a pair of holes 2811a formed at positions adjacent to two opposite ends of the 1-1th reinforcing member 281a, respectively. At least a portion of the flexible printed circuit board 243 may be disposed between the hinge structure 231 (or the hinge cover 232) and the 1-1th reinforcing member 281a. The 1-1th reinforcing member 281a may limit the movement of the flexible printed circuit board 243 when the flexible printed circuit board 243 is bent or unfolded according to the state change of the electronic device 101.

According to an embodiment, at least a portion of the 1-2th reinforcing member 281b may be fixed to the hinge structure 231 (or the hinge cover 232). For example, the 1-2th reinforcing member 281b may be coupled to the hinge structure 231 through a fastening member (e.g., bolt or pin). The fastening member may be inserted into a pair of holes 2811b formed at positions adjacent to two opposite ends of the 1-2th reinforcing member 281b, respectively. At least a portion of the flexible printed circuit board 243 may be disposed between the hinge structure 231 (or the hinge cover 232) and the 1-2th reinforcing member 281b. The 1-2th reinforcing member 281b may limit the movement (or flow) of the flexible printed circuit board 243 when the flexible printed circuit board 243 is bent or unfolded according to the state change of the electronic device 101.

According to an embodiment, at least one electromagnet 290 may be disposed on the flexible printed circuit board 243. For example, at least one electromagnet 290 may be disposed between the flexible printed circuit board 243 and the folding area (e.g., the folding area 253 of FIG. 4 or FIG. 13) of the display (e.g., the display 250 of FIG. 4).

According to an embodiment, at least one electromagnet 290 may include a first electromagnet 290a or a second electromagnet 290b spaced apart from each other.

According to an embodiment, the first electromagnet 290a may be disposed on the 1-1th reinforcing member 281a. For example, the first electromagnet 290a may be fixed to the 1-1th reinforcing member 281a. The first electromagnet 290a may be applied with current provided from the first battery (e.g., the first battery 271 of FIG. 4) disposed inside the first housing (e.g., the first housing 210 of FIG. 4). For example, the first electromagnet 290a may be applied with current from the first battery through a conductive line included in the flexible printed circuit board 243. For example, a pair of power supply portions 2911a, 2912a included in the first connector 2431 may be electrically connected to the first printed circuit board (e.g., the first printed circuit board 241 of FIG. 4), and current provided from the first battery (e.g., the first battery 271 of FIG. 4) may be provided to the first electromagnet 290a through the first printed circuit board 241 and the pair of power supply portions 2911a, 2912a. According to an embodiment, the first electromagnet 290a may be applied with current from the second battery (e.g., the second battery 272 of FIG. 4) disposed inside the second housing (e.g., the second housing 220 of FIG. 4).

According to an embodiment, the second electromagnet 290b may be disposed on the 1-2th reinforcing member 281b. For example, the second electromagnet 290b may be fixed to the 1-2th reinforcing member 281b. The second electromagnet 290b may be applied with current provided from the second battery (e.g., the second battery 272 of FIG. 4) disposed inside the second housing (e.g., the second housing 220 of FIG. 4). For example, the second electromagnet 290b may be applied with current from the second battery through a conductive line included in the flexible printed circuit board 243. For example, a pair of power supply portions 2911b, 2912b included in the second connector 2432 may be electrically connected to the second printed circuit board (e.g., the second printed circuit board 242 of FIG. 4), and current provided from the second battery (e.g., the second battery 272 of FIG. 4) may be provided to the second electromagnet 290b through the second printed circuit board 242 and the pair of power supply portions 2911b, 2912b. According to an embodiment, the second electromagnet 290b may be applied with current from the second battery (e.g., the second battery 272 of FIG. 4) disposed inside the second housing (e.g., the second housing 220 of FIG. 4).

According to an embodiment, the first electromagnet 290a and/or the second electromagnet 290b may generate magnetic force when current is applied and may not generate magnetic force when current is not applied (e.g., when current is cut off). The first electromagnet 290a and/or the second electromagnet 290b may provide magnetic force to at least one magnetic member (e.g., the at least one magnetic member 340 of FIG. 5 or the at least one magnetic member 340 of FIG. 13) of the digital pen (e.g., the digital pen 300 of FIGS. 5 to 6). The attractive force formed between the at least one electromagnet 290 and the at least one magnetic member 340 may fix the digital pen (e.g., the digital pen 300 of FIGS. 5 to 6) to at least a portion of the electronic device 101.

FIG. 13 illustrates the electronic device 101 in a folded state (e.g., FIG. 3). Referring to FIG. 13, the electronic device 101 may include a flexible display (e.g., the flexible display 250 of FIG. 4) including a first display area 251 (e.g., the first display area 251 of FIG. 4), a second display area 252 (e.g., the second display area 252 of FIG. 4), and a folding area 253 (e.g., the folding area 253 of FIG. 4).

According to an embodiment, the folding area 253 may form an accommodation space 258 capable of accommodating a digital pen (e.g., the digital pen 300 of FIG. 5) including at least one magnetic member 340 (e.g., the at least one magnetic member 340 of FIG. 5) when the electronic device 101 is in a folded state (e.g., FIG. 3) (or when the housing (e.g., the housing 201 of FIG. 3) is in a folded state). According to an embodiment, the folding area 253 may define at least a portion of the accommodation space 258 capable of accommodating the digital pen when the electronic device 101 is in a folded state.

According to an embodiment, the pen housing 301 (e.g., the pen housing 301 of FIG. 5) of the digital pen may be positioned in the accommodation space 258. For example, a user may store the digital pen in the accommodation space 258 when the electronic device 101 is in a folded state.

According to an embodiment, at least one magnetic member 340 (e.g., the at least one magnetic member 340 of FIG. 5) disposed inside the pen housing 301 may include a first magnetic member 340a or a second magnetic member 340b spaced apart from each other inside the pen housing 301.

According to an embodiment, the first magnetic member 340a and/or the second magnetic member 340b may form an attractive force with the first electromagnet 290a and/or the second electromagnet 290b. According to an embodiment, the attractive force may fix the pen housing 301 to the folding area 253. Accordingly, in the process of using the electronic device 101, the release of the digital pen from the accommodation space defined by the folding area 253 is decreased or limited, thereby enhancing the usability of the electronic device 101 and the digital pen.

According to an embodiment, when the digital pen is accommodated in the accommodation space 258, at least a portion of the folding area 253 may be positioned between the at least one magnetic member 340 and the at least one electromagnet 290. Further, when the digital pen is accommodated in the accommodation space 258, at least a portion of the electromagnetic induction panel (e.g., digitizer) of the flexible display (e.g., the flexible display 250 of FIG. 4) may be positioned between the at least one magnetic member 340 and the at least one electromagnet 290.

FIG. 14A is a view illustrating an electronic device including a plurality of housings according to an embodiment of the disclosure.

FIG. 14B is a view illustrating an electronic device including a plurality of housings according to an embodiment of the disclosure.

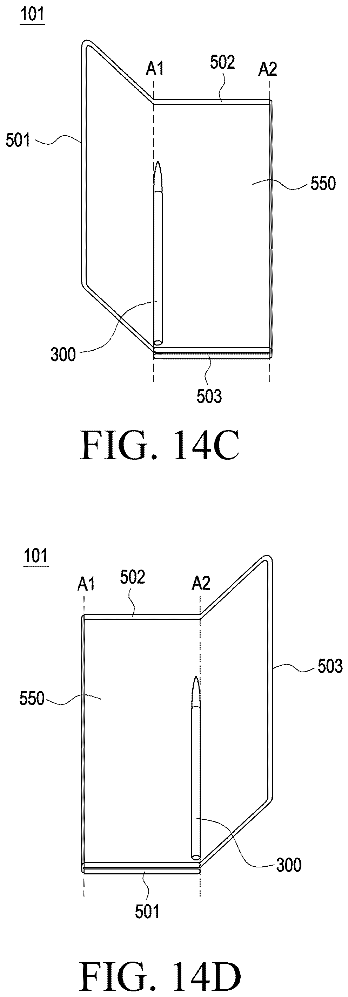

FIG. 14C is a view illustrating a digital pen and an electronic device according to an embodiment of the disclosure.

FIG. 14D is a view illustrating a digital pen and an electronic device according to an embodiment of the disclosure.

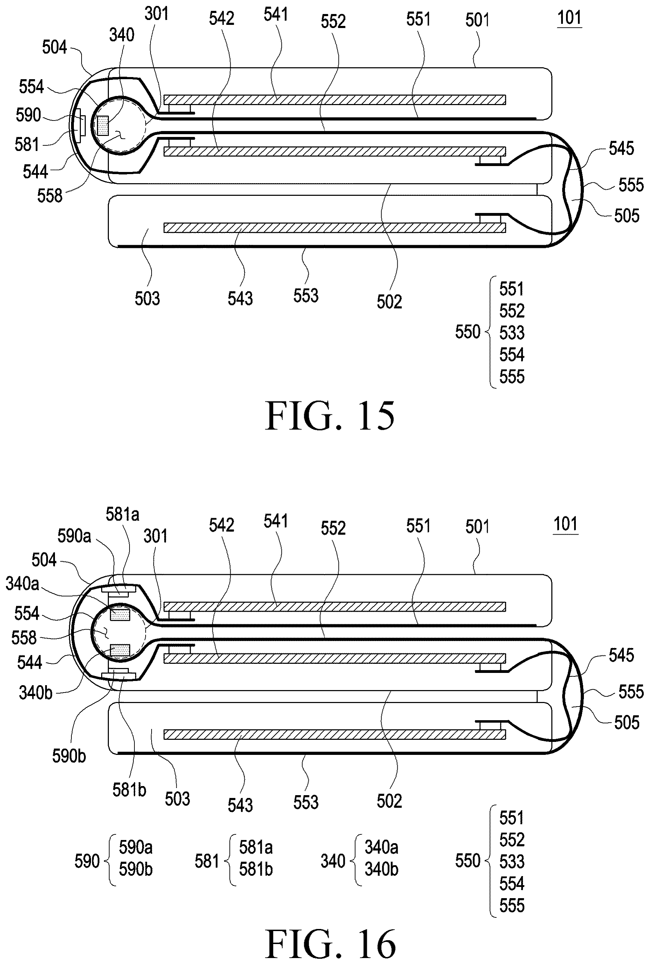

FIG. 15 is a cross-sectional view illustrating a folded state of a digital pen and an electronic device according to an embodiment of the disclosure.

FIG. 16 is a cross-sectional view illustrating a folded state of a digital pen and an electronic device according to an embodiment of the disclosure.

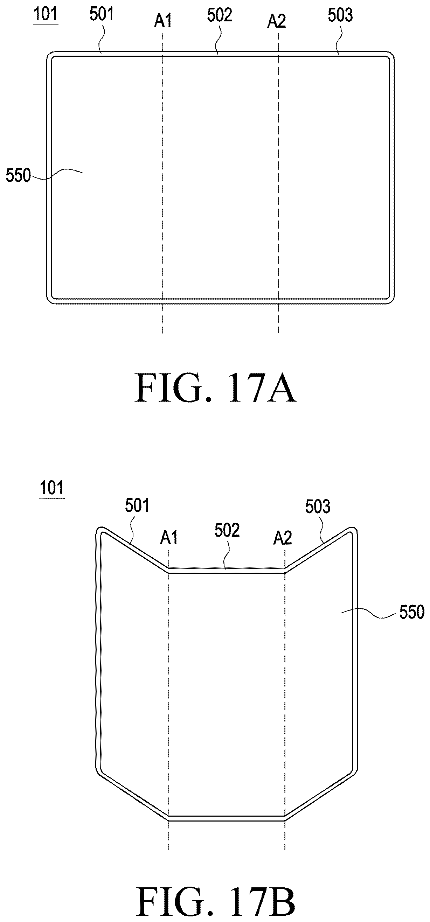

The embodiments of FIGS. 14A to 16 may be combined with the embodiments of FIGS. 1 to 13 or the embodiments of FIGS. 17A to 26.

Referring to FIGS. 14A to 16, the electronic device 101 (e.g., the electronic device 101 of FIGS. 1 to 4) may include a first housing 501, a second housing 502, a third housing 503, a first hinge structure 504, a second hinge structure 505, a first printed circuit board 541, a second printed circuit board 542, a third printed circuit board 543, a first flexible printed circuit board 544, a second flexible printed circuit board 545, a flexible display 550, at least one first reinforcing member 581, or at least one electromagnet 590.

The configuration of the first housing 501, the second housing 502, the third housing 503, the first hinge structure 504, the second hinge structure 505, the first printed circuit board 541, the second printed circuit board 542, the third printed circuit board 543, the first flexible printed circuit board 544, the second flexible printed circuit board 545, or the flexible display 550 of FIGS. 14A to 16 may be identical in whole or part to the configuration of the first housing 210, the second housing 220, the hinge structure 231, the first printed circuit board 241, the second printed circuit board 242, the flexible printed circuit board 243, or the flexible display 250 of FIG. 4.

The configuration of the first flexible printed circuit board 544, the at least one first reinforcing member 581, or the at least one electromagnet 590 of FIGS. 14A to 16 may be identical in whole or part to the configuration of the flexible printed circuit board 243, the at least one first reinforcing member 281, or the at least one electromagnet 290 of FIGS. 7 to 13.

Referring to FIGS. 14A to 14D, the electronic device 101 may include a first housing 501, a second housing 502, a third housing 503, or a flexible display 550.

According to an embodiment, the first housing 501 and the second housing 502 may be rotatable relative to each other with respect to a first folding axis A1. For example, the first housing 501 and the second housing 502 may be disposed to be folded or unfolded relative to each other with respect to the first hinge structure (e.g., the first hinge structure 504 of FIGS. 15 to 16).

According to an embodiment, the second housing 502 and the third housing 503 may be rotatable relative to each other with respect to a second folding axis A2. For example, the second housing 502 and the third housing 503 may be disposed to be folded or unfolded relative to each other with respect to the second hinge structure (e.g., the second hinge structure 505 of FIGS. 15 to 16).

According to an embodiment, the flexible display 550 may be disposed on the first housing 501, the second housing 502, and the third housing 503. The flexible display 550 may be at least partially folded or unfolded according to the state of the electronic device 101 (e.g., the folded state or unfolded state of the housings).

Referring to FIGS. 14B and 14C, the electronic device 101 may be provided with the first housing 501 and the second housing 502 in an in-folding type, and the second housing 502 and the third housing 503 may be provided in an out-folding type. Referring to FIGS. 14B and 14C, the digital pen 300 may be configured to be stored on the first folding axis A1 when the first housing 501 and the second housing 502 are folded.

Referring to FIG. 14D, the electronic device 101 may be provided with the first housing 501 and the second housing 502 in an out-folding type, and the second housing 502 and the third housing 503 may be provided in an in-folding type. Referring to FIG. 14D, the digital pen 300 may be configured to be stored on the second folding axis A2 when the second housing 502 and the third housing 503 are folded.

The in-folding type may be defined and/or referred to as a type in which the angle formed by the outer surface of the flexible display 550 disposed on the housings gradually decreases when the housings are folded relative to each other. The out-folding type may be defined and/or referred to as a type in which the angle formed by the outer surface of the flexible display 550 disposed on the housings gradually increases when the housings are folded relative to each other.

Hereinafter, FIGS. 15 to 16 are described using the electronic device 101 of FIGS. 14B to 14C as an example, but this description may be equally applied and understood to the electronic device 101 of FIG. 14D.

Referring to FIGS. 15 to 16, the electronic device 101 may include a first hinge structure 504, a second hinge structure 505, a first printed circuit board 541, a second printed circuit board 542, a third printed circuit board 543, a first flexible printed circuit board 544, a second flexible printed circuit board 545, at least one first reinforcing member 581, or at least one electromagnet 590.

According to an embodiment, the flexible display 550 may include a first display area 551 disposed on the first housing 501, a second display area 552 disposed on the second housing 502, a third display area 553 disposed on the third housing 503, a first folding area 554 connecting the first display area 551 and the second display area 552, or a second folding area 555 connecting the second display area 552 and the third display area 553.

According to an embodiment, the first hinge structure 504 may rotatably connect the first housing 501 and the second housing 502 relative to each other. The second hinge structure 505 may rotatably connect the second housing 502 and the third housing 503 relative to each other.

According to an embodiment, the first printed circuit board 541 may be disposed inside the first housing 501. The second printed circuit board 542 may be disposed inside the second housing 502. The third printed circuit board 543 may be disposed inside the third housing 503.

According to an embodiment, the first flexible printed circuit board 544 may be electrically connected to the first printed circuit board 541 and the second printed circuit board 542. The second flexible printed circuit board 545 may be electrically connected to the second printed circuit board 542 and the third printed circuit board 543.

Referring to FIG. 15, at least one first reinforcing member 581 may be disposed on the first flexible printed circuit board 544. At least one electromagnet 590 may be disposed on the at least one first reinforcing member 581. The at least one electromagnet 590 may also be directly disposed on the first flexible printed circuit board 544. The at least one electromagnet 590 may be positioned between the first hinge structure 504 and the first folding area 554.

According to an embodiment, at least one electromagnet 590 may generate magnetic force when current is applied and may not generate magnetic force when current is not applied (e.g., when current is cut off). The at least one electromagnet 590 may provide magnetic force to at least one magnetic member 340 (e.g., the at least one magnetic member 340 of FIG. 10) of the digital pen 300. The attractive force formed between the at least one electromagnet 590 and the at least one magnetic member 340 may fix the digital pen 300 to at least a portion of the electronic device 101.

According to an embodiment, the first folding area 554 may form an accommodation space 558 capable of accommodating the digital pen 300 including at least one magnetic member 340 when the electronic device 101 is in a folded state (or when the first housing 501 and the second housing 502 are in a folded state). According to an embodiment, the first folding area 554 may define at least a portion of the accommodation space 558 capable of accommodating the digital pen 300 when the electronic device 101 is in a folded state.

According to an embodiment, the pen housing 301 (e.g., the pen housing 301 of FIG. 5) of the digital pen 300 may be positioned in the accommodation space 558. For example, a user may store the digital pen 300 in the accommodation space 558 when the first housing 501 and the second housing 502 are folded relative to each other.

According to an embodiment, at least one magnetic member 340 disposed inside the pen housing 301 may form an attractive force with the at least one electromagnet 590. According to an embodiment, the attractive force may fix the pen housing 301 to the first folding area 554. Accordingly, in the process of using the electronic device 101, the release of the digital pen 300 from the accommodation space 558 defined by the first folding area 554 is decreased or limited, thereby enhancing the usability of the electronic device 101 and the digital pen 300.

Referring to FIG. 16, at least one first reinforcing member 581 may include a 1-1th reinforcing member 581a and a 1-2th reinforcing member 581b spaced apart from the 1-1th reinforcing member 581a. At least one electromagnet 590 may include a first electromagnet 590a disposed on the 1-1th reinforcing member 581a and a second electromagnet 590b disposed on the 1-2th reinforcing member 581b. The 1-1th reinforcing member 581a and/or the 1-2th reinforcing member 581b may be defined and/or referred to as a first reinforcing member 581a and/or a second reinforcing member 581b.

According to an embodiment, the first electromagnet 590a and/or the second electromagnet 590b may be positioned between the first hinge structure 504 and the first folding area 554.

According to an embodiment, the pen housing 301 (e.g., the pen housing 301 of FIG. 5) of the digital pen 300 may be positioned in the accommodation space. For example, a user may store the digital pen 300 in the accommodation space 558 when the first housing 501 and the second housing 502 are folded relative to each other.

According to an embodiment, at least one magnetic member 340 disposed inside the pen housing 301 may form an attractive force with the at least one electromagnet 590. For example, the first magnetic member 340a may form an attractive force with the first electromagnet 590a, and the second magnetic member 340b may form an attractive force with the second electromagnet 590b. According to an embodiment, the attractive force may fix the pen housing 301 to the first folding area 554. Accordingly, in the process of using the electronic device 101, the release of the digital pen 300 from the accommodation space 558 defined by the first folding area 554 is decreased or limited, thereby enhancing the usability of the electronic device 101 and the digital pen 300.

FIG. 17A is a view illustrating an electronic device including a plurality of housings according to an embodiment of the disclosure.

FIG. 17B is a view illustrating an electronic device including a plurality of housings according to an embodiment of the disclosure.

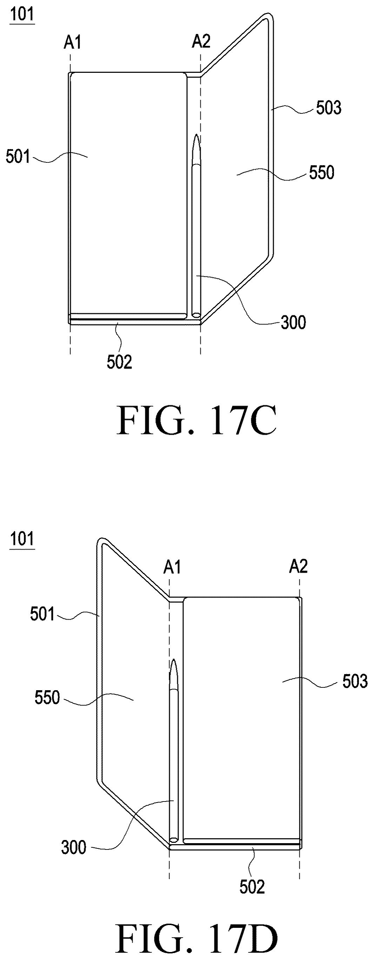

FIG. 17C is a view illustrating a digital pen and an electronic device according to an embodiment of the disclosure.

FIG. 17D is a view illustrating a digital pen and an electronic device according to an embodiment of the disclosure.

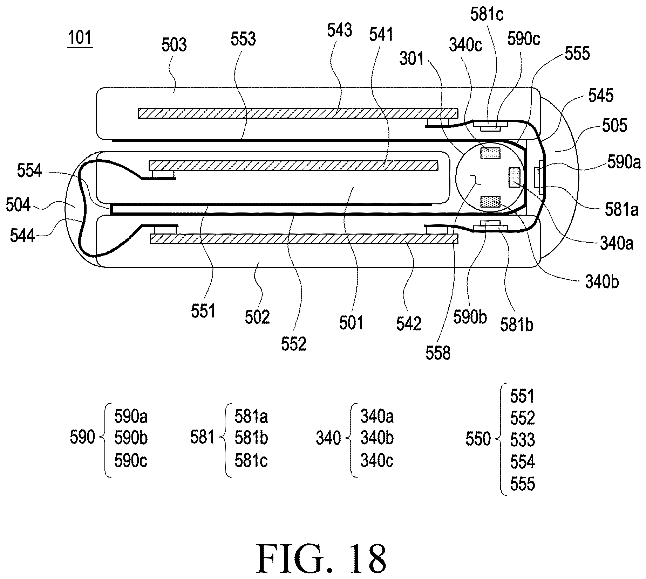

FIG. 18 is a cross-sectional view illustrating a folded state of a digital pen and an electronic device according to an embodiment of the disclosure.

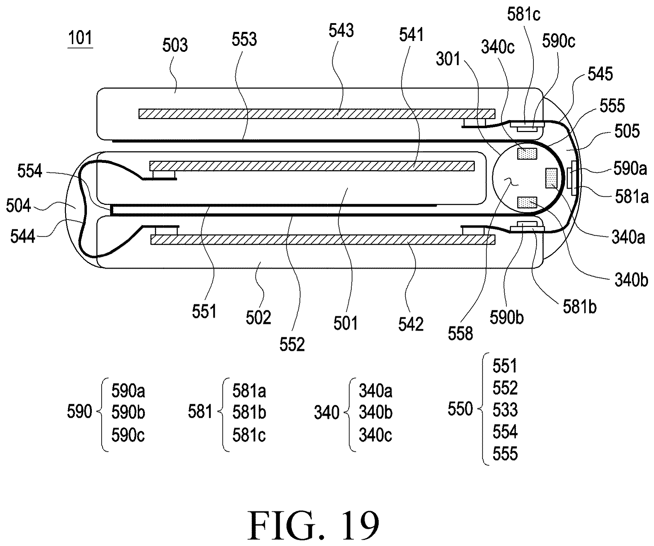

FIG. 19 is a cross-sectional view illustrating a folded state of a digital pen and an electronic device according to an embodiment of the disclosure.

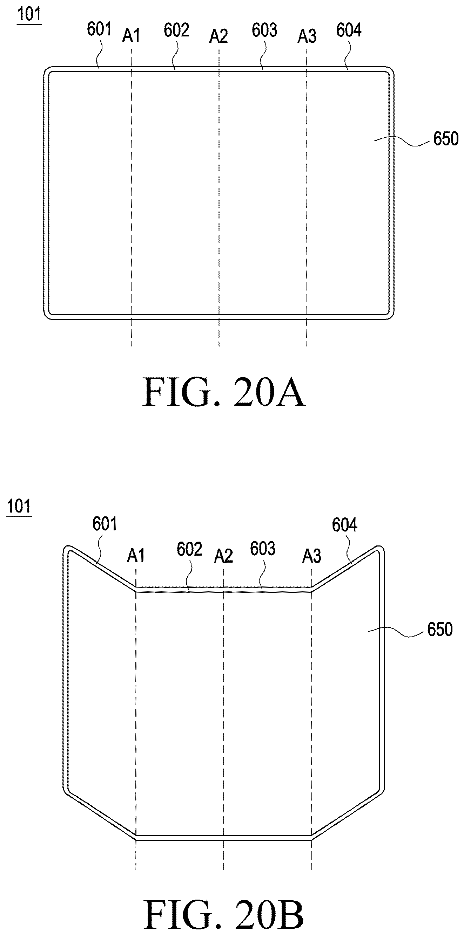

The embodiments of FIGS. 17A to 19 may be combined with the embodiments of FIGS. 1 to 16 or the embodiments of FIGS. 20A to 26.

Referring to FIGS. 17A to 19, an electronic device 101 (e.g., the electronic device 101 of FIGS. 1 to 4) may include a first housing 501, a second housing 502, a third housing 503, a first hinge structure 504, a second hinge structure 505, a first printed circuit board 541, a second printed circuit board 542, a third printed circuit board 543, a first flexible printed circuit board 544, a second flexible printed circuit board 545, a flexible display 550, at least one first reinforcing member 581, or at least one electromagnet 590.

The configuration of the first housing 501, the second housing 502, the third housing 503, the first hinge structure 504, the second hinge structure 505, the first printed circuit board 541, the second printed circuit board 542, the third printed circuit board 543, the first flexible printed circuit board 544, the second flexible printed circuit board 545, the flexible display 550, the at least one first reinforcing member 581, or the at least one electromagnet 590 of FIGS. 17A to 19 may be identical in whole or part to the first housing 501, the second housing 502, the third housing 503, the first hinge structure 504, the second hinge structure 505, the first printed circuit board 541, the second printed circuit board 542, the third printed circuit board 543, the first flexible printed circuit board 544, the second flexible printed circuit board 545, the flexible display 550, the at least one first reinforcing member 581, or the at least one electromagnet 590 of FIGS. 14A to 16.

Referring to FIGS. 17A to 17D, the electronic device 101 may include a first housing 501, a second housing 502, a third housing 503, or a flexible display 550.

According to an embodiment, the first housing 501 and the second housing 502 may be rotatable relative to each other with respect to a first folding axis A1. For example, the first housing 501 and the second housing 502 may be disposed to be folded or unfolded relative to each other with respect to the first hinge structure (e.g., the first hinge structure 504 of FIGS. 18 to 19).

According to an embodiment, the second housing 502 and the third housing 503 may be rotatable relative to each other with respect to a second folding axis A2. For example, the second housing 502 and the third housing 503 may be disposed to be folded or unfolded relative to each other with respect to the second hinge structure (e.g., the second hinge structure 505 of FIGS. 18 to 19).

According to an embodiment, the flexible display 550 may be disposed on the first housing 501, the second housing 502, and the third housing 503. The flexible display 550 may be at least partially folded or unfolded according to the state of the electronic device 101 (e.g., the folded state or unfolded state of the housings).

According to an embodiment, the electronic device 101 may be provided with the first housing 501 and the second housing 502 in an in-folding type, and the second housing 502 and the third housing 503 may be provided in an in-folding type. Referring to FIG. 17C, the digital pen 300 may be configured to be stored on the second folding axis A2 when the second housing 502 and the third housing 503 are folded. Referring to FIG. 17D, the digital pen 300 may be configured to be stored on the first folding axis A1 when the first housing 501 and the second housing 502 are folded.

The in-folding type may be defined and/or referred to as a type in which the angle formed by the outer surface of the flexible display 550 disposed on the housings gradually decreases when the housings are folded relative to each other.

Hereinafter, FIGS. 18 and 19 are described using the electronic device 101 of FIG. 17C as an example, but this description may be equally applied and understood to the electronic device 101 of FIG. 17D.

Referring to FIGS. 18 to 19, an electronic device 101 may include a first hinge structure 504, a second hinge structure 505, a first printed circuit board 541, a second printed circuit board 542, a third printed circuit board 543, a first flexible printed circuit board 544, a second flexible printed circuit board 545, at least one first reinforcing member 581, or at least one electromagnet 590.

According to an embodiment, the flexible display 550 may include a first display area 551 disposed on the first housing 501, a second display area 552 disposed on the second housing 502, a third display area 553 disposed on the third housing 503, a first folding area 554 connecting the first display area 551 and the second display area 552, or a second folding area 555 connecting the second display area 552 and the third display area 553.

According to an embodiment, the first hinge structure 504 may rotatably connect the first housing 501 and the second housing 502 relative to each other. The second hinge structure 505 may rotatably connect the second housing 502 and the third housing 503 relative to each other.

According to an embodiment, the first printed circuit board 541 may be disposed inside the first housing 501. The second printed circuit board 542 may be disposed inside the second housing 502. The third printed circuit board 543 may be disposed inside the third housing 503.

According to an embodiment, the first flexible printed circuit board 544 may be electrically connected to the first printed circuit board 541 and the second printed circuit board 542. The second flexible printed circuit board 545 may be electrically connected to the second printed circuit board 542 and the third printed circuit board 543.

According to an embodiment, when the electronic device 101 is fully folded, the first housing 501 may be disposed between the second housing 502 and the third housing 503.

According to an embodiment, when the electronic device 101 is fully folded, an accommodation space 558 capable of accommodating the digital pen 300 may be formed between the second folding area 555 and the edge of the first housing 501.

According to an embodiment (e.g., FIG. 18), in the electronic device 101, when the second folding area 555 is folded, at least a partial area of the second folding area 555 may be positioned inside the second hinge structure 505. According to an embodiment (e.g., FIG. 19), in the electronic device 101, when the second folding area 555 is folded, all areas of the second folding area 555 may not be positioned inside the second hinge structure 505.

Referring to FIGS. 18 and 19, at least one first reinforcing member 590 may be disposed on the second flexible printed circuit board 545. At least one electromagnet 590 may be disposed on the at least one first reinforcing member 581. The at least one electromagnet 590 may also be directly disposed on the second flexible printed circuit board 545.

According to an embodiment, at least one first reinforcing member 581 may include a 1-1th reinforcing member 581a, a 1-2th reinforcing member 581b, and a 1-3th reinforcing member 581c. The 1-1th reinforcing member 581a may be disposed on the second hinge structure 505. The 1-2th reinforcing member 581b may be disposed on the third housing 503. The 1-3th reinforcing member 581c may be disposed on the second housing 502. The 1-1th reinforcing member 581a, the 1-2th reinforcing member 581b, and/or the 1-3th reinforcing member 581c may be defined and/or referred to as a first reinforcing member 581a, a second reinforcing member 581b, and a 1-3th reinforcing member 581c.

According to an embodiment, at least one electromagnet 590 may include a first electromagnet 590a, a second electromagnet 590b, and a third electromagnet 590c. The first electromagnet 590a may be disposed on the 1-1th reinforcing member 581a. The second electromagnet 590b may be disposed on the 1-2th reinforcing member 581b. The third electromagnet 590c may be disposed on the 1-3th reinforcing member 581c. The at least one electromagnet 590 may be positioned between the second hinge structure 505 and the second folding area 555.

According to an embodiment, at least one electromagnet 590 may generate magnetic force when current is applied and may not generate magnetic force when current is not applied (e.g., when current is cut off). The at least one electromagnet 590 may provide magnetic force to at least one magnetic member 340 (e.g., the at least one magnetic member 340 of FIG. 10) of the digital pen 300. The attractive force formed between the at least one electromagnet 590 and the at least one magnetic member 340 may fix the digital pen 300 to at least a portion of the electronic device 101.

According to an embodiment, the second folding area 555 may form an accommodation space 558 capable of accommodating the digital pen 300 including at least one magnetic member 340 when the electronic device 101 is in a folded state (or when the second housing 502 and the third housing 503 are in a folded state). According to an embodiment, the second folding area 555 may define at least a portion of the accommodation space 558 capable of accommodating the digital pen 300 when the electronic device 101 is in a folded state.

According to an embodiment, the pen housing 301 (e.g., the pen housing 301 of FIG. 5) of the digital pen 300 may be positioned in the accommodation space 558. For example, a user may store the digital pen 300 in the accommodation space when the second housing 502 and the third housing 503 are folded relative to each other.

According to an embodiment, at least one magnetic member 340 disposed inside the pen housing 301 may form an attractive force with the at least one electromagnet 590. For example, the first magnetic member 340a may form an attractive force with the first electromagnet 590a, the second magnetic member 340b may form an attractive force with the second electromagnet 590b, and the third magnetic member 340c may form an attractive force with the third electromagnet 590c. According to an embodiment, the attractive force may fix the pen housing 301 to the second folding area 555. Accordingly, in the process of using the electronic device 101, the release of the digital pen 300 from the accommodation space 558 defined by the second folding area 555 is decreased or limited, thereby enhancing the usability of the electronic device 101 and the digital pen 300.

FIG. 20A is a view illustrating an electronic device including a plurality of housings according to an embodiment of the disclosure.

FIG. 20B is a view illustrating an electronic device including a plurality of housings according to an embodiment of the disclosure.

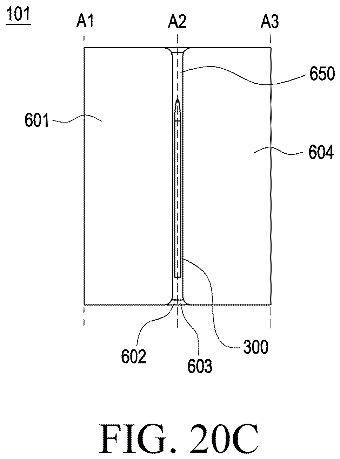

FIG. 20C is a view illustrating a digital pen and an electronic device according to an embodiment of the disclosure.

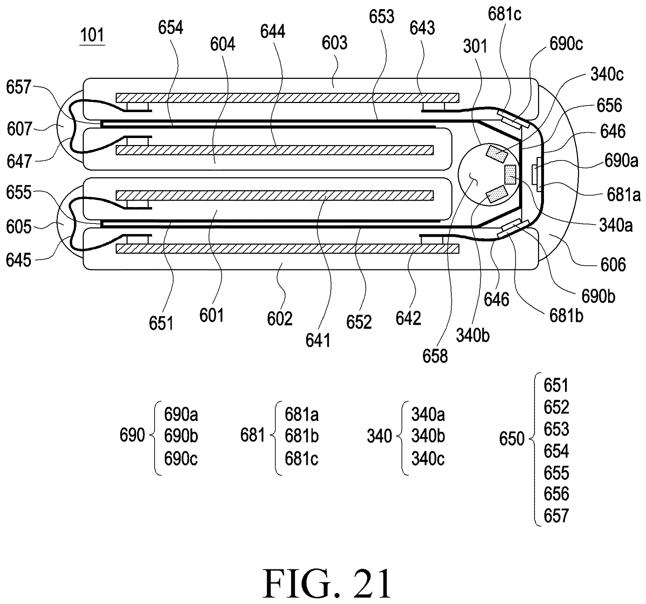

FIG. 21 is a cross-sectional view illustrating a folded state of a digital pen and an electronic device according to an embodiment of the disclosure.

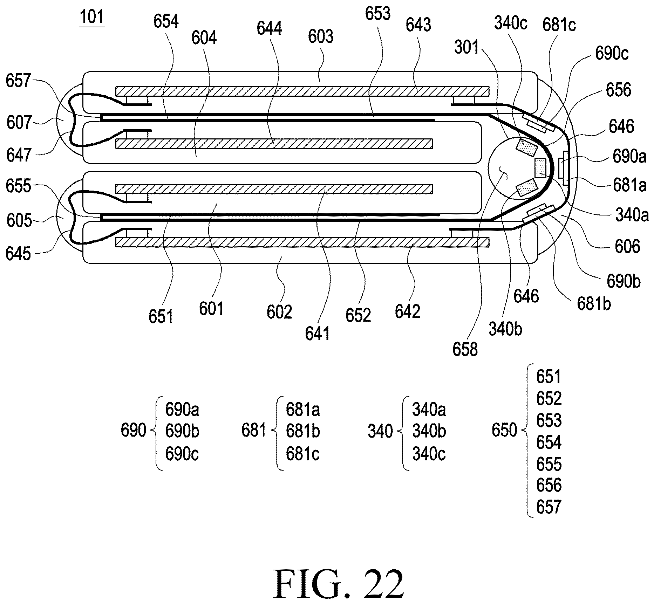

FIG. 22 is a cross-sectional view illustrating a folded state of a digital pen and an electronic device according to an embodiment of the disclosure.

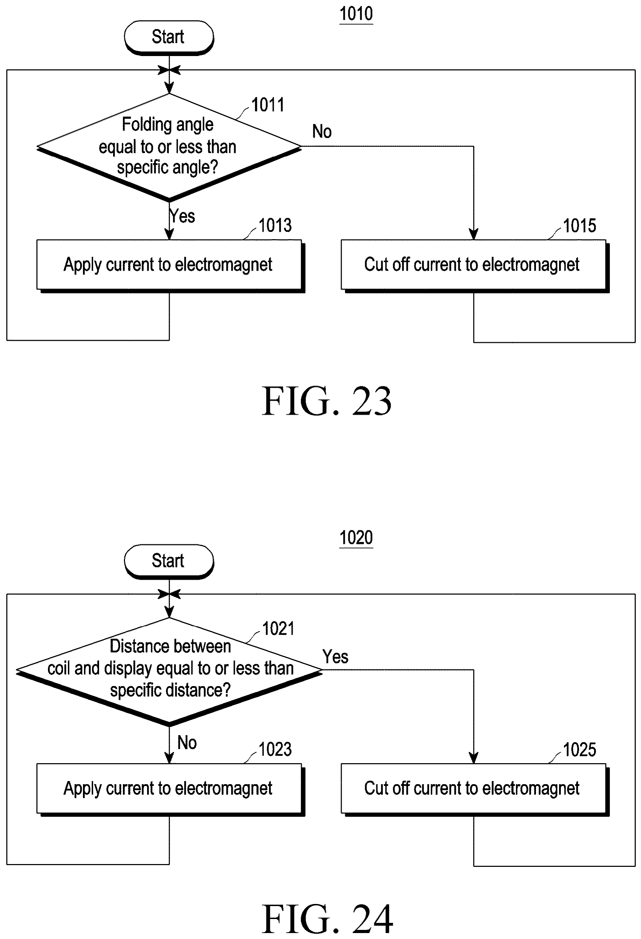

The embodiments of FIGS. 20A to 22 may be combined with the embodiments of FIGS. 1 to 19 or the embodiments of FIGS. 23 to 26.

Referring to FIGS. 20A to 21, an electronic device 101 (e.g., the electronic device 101 of FIGS. 1 to 4) may include a first housing 601, a second housing 602, a third housing 603, a fourth housing 604, a first hinge structure 605, a second hinge structure 606, a third hinge structure 607, a first printed circuit board 641, a second printed circuit board 642, a third printed circuit board 643, a fourth printed circuit board 644, a first flexible printed circuit board 645, a second flexible printed circuit board 646, a third flexible printed circuit board 647, a flexible display 650, at least one first reinforcing member 681, or at least one electromagnet 690.

The configuration of the first housing 601, the second housing 602, the third housing 603, the fourth housing 604, the first hinge structure 605, the second hinge structure 606, the third hinge structure 607, the first printed circuit board 641, the second printed circuit board 642, the third printed circuit board 643, the fourth printed circuit board 644, the first flexible printed circuit board 645, the second flexible printed circuit board 646, the third flexible printed circuit board 647, the flexible display 650, the at least one first reinforcing member 681, or the at least one electromagnet 690 of FIGS. 20A to 22 may be identical in whole or part to the first housing 501, the second housing 502, the third housing 503, the first hinge structure 504, the second hinge structure 505, the first printed circuit board 541, the second printed circuit board 542, the third printed circuit board 543, the first flexible printed circuit board 544, the second flexible printed circuit board 545, the flexible display 550, the at least one first reinforcing member 581, or the at least one electromagnet 590 of FIGS. 14A to 16.

Referring to FIGS. 21A to 22, the electronic device 101 may include a first housing 601, a second housing 602, a third housing 603, a fourth housing 604, or a flexible display 650.

According to an embodiment, the first housing 601 and the second housing 602 may be rotatable relative to each other with respect to a first folding axis A1. For example, the first housing 601 and the second housing 602 may be disposed to be folded or unfolded relative to each other with respect to the first hinge structure (e.g., the first hinge structure 605 of FIG. 2).

According to an embodiment, the second housing 602 and the third housing 603 may be rotatable relative to each other with respect to a second folding axis A2. For example, the second housing 602 and the second housing 603 may be disposed to be folded or unfolded relative to each other with respect to the second hinge structure (e.g., the second hinge structure 606 of FIG. 21).

According to an embodiment, the third housing 603 and the fourth housing 604 may be rotatable relative to each other with respect to a third folding axis A3. For example, the third housing 603 and the fourth housing 604 may be disposed to be folded or unfolded relative to each other with respect to the third hinge structure (e.g., the third hinge structure 607 of FIG. 21).

According to an embodiment, the flexible display 650 may be disposed on the first housing 601, the second housing 602, the third housing 603, and the fourth housing 604. The flexible display 650 may be at least partially folded or unfolded according to the state of the electronic device 101 (e.g., the folded state or unfolded state of the housings).

According to an embodiment, the electronic device 101 may be provided with the first housing 601 and the second housing 602 in an in-folding type, the second housing 602 and the third housing 603 may be provided in an in-folding type, and the third housing 603 and the fourth housing 604 may be provided in an in-folding type. Referring to FIG. 21, the digital pen 300 may be configured to be stored on the third folding axis A3.

The in-folding type may be defined and/or referred to as a type in which the angle formed by the outer surface of the flexible display 650 disposed on the housings gradually decreases when the housings are folded relative to each other.

Referring to FIGS. 21 and 22, an electronic device 101 may include a first hinge structure 605, a second hinge structure 606, a third hinge structure 607, a first printed circuit board 641, a second printed circuit board 642, a third printed circuit board 643, a fourth printed circuit board 644, a first flexible printed circuit board 645, a second flexible printed circuit board 646, a third flexible printed circuit board 647, at least one first reinforcing member 681, or at least one electromagnet 690.

According to an embodiment, the flexible display 650 may include a first display area 651 disposed on the first housing 601, a second display area 652 disposed on the second housing 602, a third display area 653 disposed on the third housing 603, a fourth display area 654 disposed on the fourth housing 604, a first folding area 655 connecting the first display area 651 and the second display area 652, a second folding area 656 connecting the second display area 652 and the third display area 653, or a third folding area 657 connecting the third display area 653 and the fourth display area 654.

According to an embodiment, the first hinge structure 605 may rotatably connect the first housing 601 and the second housing 602 relative to each other. The second hinge structure 606 may rotatably connect the second housing 602 and the third housing 603 relative to each other.

According to an embodiment, the first printed circuit board 641 may be disposed inside the first housing 601. The second printed circuit board 642 may be disposed inside the second housing 602. The third printed circuit board 643 may be disposed inside the third housing 603. The fourth printed circuit board 644 may be disposed inside the fourth housing 604.

According to an embodiment, the first flexible printed circuit board 645 may be electrically connected to the first printed circuit board 641 and the second printed circuit board 642. The second flexible printed circuit board 646 may be electrically connected to the second printed circuit board 642 and the third printed circuit board 643. The second flexible printed circuit board 646 may be electrically connected to the second printed circuit board 642 and the third printed circuit board 643.

According to an embodiment, when the electronic device 101 is fully folded, the first housing 601 and the fourth housing 604 may be disposed between the second housing 602 and the third housing 603.

According to an embodiment, when the electronic device 101 is fully folded, an accommodation space 658 capable of accommodating the digital pen 300 may be formed between the second folding area 656 and the edge of the first housing 601 and the edge of the fourth housing 604.

According to an embodiment (e.g., FIG. 21), in the electronic device 101, when the second folding area 656 is folded, all areas of the second folding area 656 may not be positioned inside the second hinge structure 606. According to an embodiment (e.g., FIG. 22), in the electronic device 101, when the second folding area 656 is folded, at least a partial area of the second folding area 656 may be positioned inside the second hinge structure 606.

Referring to FIGS. 20 and 21, at least one first reinforcing member 681 may be disposed on the second flexible printed circuit board 646. At least one electromagnet 690 may be disposed on the at least one first reinforcing member 681. The at least one electromagnet 690 may also be directly disposed on the second flexible printed circuit board 646.

According to an embodiment, at least one first reinforcing member 681 may include a 1-1th reinforcing member 681a, a 1-2th reinforcing member 681b, and a 1-3th reinforcing member 681c. The 1-1th reinforcing member 681a may be disposed on the second hinge structure 606. The 1-2th reinforcing member 681b may be disposed on the second hinge structure 606 or the second housing 602. The 1-3th reinforcing member 681c may be disposed on the second hinge structure 606 or the third housing 603. The 1-1th reinforcing member 681a, the 1-2th reinforcing member 681b, and/or the 1-3th reinforcing member 681c may be defined and/or referred to as a first reinforcing member 681a, a second reinforcing member 681b, and a 1-3th reinforcing member 681c.

According to an embodiment, at least one electromagnet 690 may include a first electromagnet 690a, a second electromagnet 690b, and a third electromagnet 690c. The first electromagnet 690a may be disposed on the 1-1th reinforcing member 681a. The second electromagnet 690b may be disposed on the 1-2th reinforcing member 681b. The third electromagnet 690c may be disposed on the 1-3th reinforcing member 681c. The at least one electromagnet 690 may be positioned between the second hinge structure 606 and the second folding area 654.

According to an embodiment, at least one electromagnet 690 may generate magnetic force when current is applied and may not generate magnetic force when current is not applied (e.g., when current is cut off). The at least one electromagnet 690 may provide magnetic force to at least one magnetic member 340 (e.g., the at least one magnetic member 340 of FIG. 10) of the digital pen 300. The attractive force formed between the at least one electromagnet 690 and the at least one magnetic member 340 may fix the digital pen 300 to at least a portion of the electronic device 101.

According to an embodiment, the second folding area 656 may form an accommodation space 658 capable of accommodating the digital pen 300 including at least one magnetic member 340 when the electronic device 101 is in a folded state (or when the second housing 602 and the third housing 603 are in a folded state). According to an embodiment, the second folding area 656 may define at least a portion of the accommodation space 658 capable of accommodating the digital pen 300 when the electronic device 101 is in a folded state.

According to an embodiment, the pen housing 301 (e.g., the pen housing 301 of FIG. 5) of the digital pen 300 may be positioned in the accommodation space 658. For example, a user may store the digital pen 300 in the accommodation space 658 when the second housing 602 and the third housing 603 are folded relative to each other.

According to an embodiment, at least one magnetic member 340 disposed inside the pen housing 301 may form an attractive force with the at least one electromagnet 690. For example, the first magnetic member 340a may form an attractive force with the first electromagnet 690a, the second magnetic member 340b may form an attractive force with the second electromagnet 690b, and the third magnetic member 340c may form an attractive force with the third electromagnet 690c. According to an embodiment, the attractive force may fix the pen housing 301 to the second folding area 656. Accordingly, in the process of using the electronic device 101, the release of the digital pen 300 from the accommodation space 658 defined by the second folding area 656 is decreased or limited, thereby enhancing the usability of the electronic device 101 and the digital pen 300.

Hereinafter, the embodiments of FIGS. 23 to 26 are described as examples to describe the current application operation or current cut-off operation for at least one electromagnet of the electronic device. For convenience of description, the electronic device, flexible display, or electromagnet of FIGS. 4, 7, and 10 is described as examples, but this description may be equally applied and understood to the electronic device, flexible display, or at least one electromagnet of FIGS. 11 to 22.

The flexible display 250 of FIGS. 4, 7, and 10 may include an electromagnetic induction panel (e.g., digitizer). The electromagnetic induction panel may detect a resonance frequency formed in the coil portion (e.g., the coil portion 320 of FIG. 5) of the digital pen 300, and the processor (e.g., the processor 120 of FIG. 1) of the electronic device 101 may receive information about the detected resonance frequency and may detect a user's handwriting input based on the information.

The processor 120 of the electronic device 101 may be configured to control the first battery (e.g., the first battery 271 of FIG. 4) so that current is not applied to at least one electromagnet 290 when a user uses the digital pen 300. For example, when current is applied to at least one electromagnet 290, the magnetic force generated from at least one electromagnet 290 may form noise in the electromagnetic induction panel for detecting the coil portion 320 of the digital pen 300. To prevent the formation of the noise, the processor 120 of the electronic device 101 may control the first battery (e.g., the first battery 271 of FIG. 4) so that current is cut off to at least one electromagnet 290 when a user uses the digital pen 300 for a handwriting input.

The processor 120 of the electronic device 101 may be configured to control the first battery so that current is applied to at least one electromagnet 290 when a user does not use the digital pen 300. For example, when current is applied to at least one electromagnet 290, the magnetic force generated from at least one electromagnet 290 may form an attractive force with at least one magnetic member 340 of the digital pen 300. To fix the digital pen 300 to the folding area 253, or to fix the digital pen 300 accommodated in the accommodation space 258 to the folding area 253, the processor 120 of the electronic device 101 may control the first battery so that current is applied to at least one electromagnet 290.

FIG. 23 is a flowchart 1010 for describing a current application process for an electromagnet of an electronic device according to an embodiment of the disclosure.

The embodiment of FIG. 23 may be combinable with the embodiments of FIGS. 1 to 22, or the embodiments of FIGS. 24 to 26.

Referring to FIGS. 4, 7, 10, and 23, the processor (e.g., the processor 120 of FIG. 1) of the electronic device 101 may be configured to identify whether the folding angle of the electronic device 101 is equal to or less than a specific angle (1011). For example, the folding angle of the electronic device 101 may be an angle formed between the first housing 210 and the second housing 220. The folding angle of the electronic device 101 may be defined and/or referred to as the folding angle of the housing (e.g., the housing 201 of FIGS. 2 to 3). For example, the specific angle may be a predesignated angle (or a preset angle) stored in the memory (e.g., the memory 130 of FIG. 1). For example, the specific angle may be defined and/or interpreted as a threshold angle stored in the memory.

According to an embodiment, the processor 120 of the electronic device 101 may receive information about the current folding angle of the electronic device 101.

The information about the current folding angle of the electronic device 101 may be generated through the difference between acceleration sensor values measured from an acceleration sensor (e.g., the sensor module 176 of FIG. 1) disposed (or mounted) on the first display area (e.g., the first display area 251 of FIG. 4) and an acceleration sensor (e.g., the sensor module 176 of FIG. 1) disposed (or mounted) on the second display area (e.g., the second display area 252 of FIG. 4).

The processor 120 of the electronic device 101 may map a difference value, which is the difference between a first value measured from the acceleration sensor disposed on the first display area 251 and a second value measured from the acceleration sensor disposed on the second display area 252, with a value for the folding angle stored in the memory 130. For example, information about the folding angle corresponding to the difference value may be stored in the memory 130 of the electronic device 101. The processor 120 of the electronic device 101 may obtain or identify the folding angle value stored in the memory 130 that is mapped with the difference value. The processor 120 of the electronic device 101 may be configured to recognize the obtained folding angle value as the current folding angle of the electronic device 101.

The information about the current folding angle of the electronic device 101 may be generated through a distance value to the second display area 252 detected from a touch sensor (e.g., the sensor module 176 of FIG. 1) disposed (or mounted) on the first display area 251, and a distance value to the first display area 251 detected from a touch sensor (e.g., the sensor module 176 of FIG. 1) disposed (or mounted) on the second display area 252.

The processor 120 of the electronic device 101 may map a difference value, which is the difference between a first value measured from the touch sensor disposed on the first display area 251 and a second value measured from the touch sensor disposed on the second display area 252, with a value for the folding angle stored in the memory 130. For example, information about the folding angle corresponding to the difference value may be stored in the memory 130 of the electronic device 101. The processor 120 of the electronic device 101 may obtain or identify the folding angle value stored in the memory 130 that is mapped with the difference value. The processor 120 of the electronic device 101 may be configured to recognize the obtained folding angle value as the current folding angle of the electronic device 101.

The information about the current folding angle of the electronic device 101 may be generated through a magnet disposed on the 1-1th side surface 211a and a hall sensor (e.g., the sensor module 176 of FIG. 1) disposed on the 2-1th side surface 221a. The magnet may be disposed on the 2-1th side surface 221a, and the hall sensor may be disposed on the 1-1th side surface 211a. The hall sensor may be configured to detect the magnet.

The processor 120 of the electronic device 101 may map a magnetic force value detected by the hall sensor with a value for the folding angle stored in the memory 130. For example, information about the folding angle corresponding to the magnetic force value may be stored in the memory 130 of the electronic device 101. The processor 120 of the electronic device 101 may obtain or identify the folding angle value stored in the memory 130 that is mapped with the magnetic force value. The processor 120 of the electronic device 101 may be configured to recognize the obtained folding angle value as the current folding angle of the electronic device 101.

The processor 120 of the electronic device 101 may be generated through a resistance value detected from a variable resistance sensor (e.g., the sensor module 176 of FIG. 1) disposed on the hinge structure 231.

The processor 120 of the electronic device 101 may map a resistance value detected by the variable resistance sensor with a value for the folding angle stored in the memory 130. For example, information about the folding angle corresponding to the resistance value may be stored in the memory 130 of the electronic device 101. The processor 120 of the electronic device 101 may obtain or identify the folding angle value stored in the memory 130 that is mapped with the resistance value. The processor 120 of the electronic device 101 may be configured to recognize the obtained folding angle value as the current folding angle of the electronic device 101.

The processor 120 of the electronic device 101 may control the first battery 271 to apply current to at least one electromagnet 290 when the folding angle of the electronic device 101 is equal to or less than a specific angle (1013). For example, when the folding angle of the electronic device 101 is equal to or less than a specific angle, it may be a state in which a user is not using the digital pen 300 of the electronic device 101. When the folding angle of the electronic device 101 is equal to or less than a specific angle, the processor 120 of the electronic device 101 may be configured to determine that a non-use event of the digital pen 300 occurs. When a non-use event of the digital pen 300 occurs, the processor 120 of the electronic device 101 may control the first battery 271 so that current is applied to at least one electromagnet 290. At least one electromagnet 290 may generate magnetic force to form an attractive force with at least one magnetic member 340 of the digital pen 300 when current is applied. For example, a state in which the folding angle of the electronic device 101 is equal to or less than a specific angle may be defined and/or interpreted as a state in which the housing (e.g., the housing 201 of FIGS. 2 to 3) of the electronic device 101 is folded. For example, the processor 120 of the electronic device 101 may be configured to determine that a non-use event of the digital pen 300 occurs when the housing of the electronic device 101 is in a folded state. For example, the processor 120 of the electronic device 101 may control the first battery 271 so that current is applied to at least one electromagnet 290 when the housing is in a folded state.

The processor 120 of the electronic device 101 may control the first battery 271 to cut off current to at least one electromagnet 290 when the folding angle of the electronic device 101 exceeds a specific angle (1015). For example, when the folding angle of the electronic device 101 exceeds a specific angle, it may be a state in which a user is using or intending to use the digital pen 300 of the electronic device 101. When the folding angle of the electronic device 101 exceeds a specific angle, the processor 120 of the electronic device 101 may be configured to determine that a use event of the digital pen 300 occurs. When a use event of the digital pen 300 occurs, the processor 120 of the electronic device 101 may control the first battery 271 so that current is not applied to at least one electromagnet 290. At least one electromagnet 290 may not generate magnetic force when current is not applied. For example, a state in which the folding angle of the electronic device 101 exceeds a specific angle may be defined and/or interpreted as a state in which the housing (e.g., the housing 201 of FIGS. 2 to 3) of the electronic device 101 is unfolded. For example, the processor 120 of the electronic device 101 may be configured to determine that a use event of the digital pen 300 occurs when the housing of the electronic device 101 is in an unfolded state. For example, the processor 120 of the electronic device 101 may control the first battery 271 so that current is not applied to at least one electromagnet 290 when the housing is in an unfolded state.

According to an embodiment, the processor 120 of the electronic device 101 may be configured to control the first battery 271 or the power management module (e.g., the power management module 188 of FIG. 1) to apply current to at least one electromagnet 290 or to cut off current to at least one electromagnet 290.

FIG. 24 is a flowchart 1020 for describing a current application process for an electromagnet of an electronic device according to an embodiment of the disclosure.

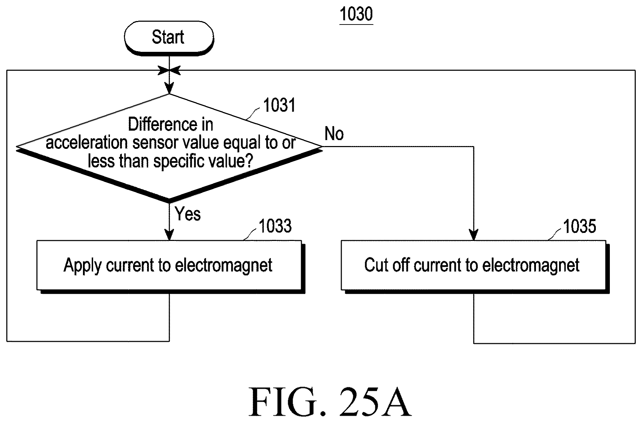

The embodiment of FIG. 24 may be combined with the embodiments of FIGS. 1 to 23 or the embodiments of FIGS. 25A to 26.

Referring to FIGS. 4, 7, 10, and 24, the processor (e.g., the processor 120 of FIG. 1) of the electronic device 101 may be configured to identify whether the distance between the coil (e.g., the coil 323 of FIG. 5) of the digital pen (e.g., the digital pen 300 of FIG. 5) and the display 250 is equal to or less than a specific distance (1021). For example, the distance between the coil 323 of the digital pen 300 and the display 250 of the electronic device 101 may be the minimum distance between the coil 323 and the display 250. Information about the distance between the coil 323 and the display 250 may be generated based on information detected by the electromagnetic induction panel of the display 250. The specific distance may be a predesignated value in the memory 130. For example, the specific distance may be defined and/or interpreted as a threshold distance stored in the memory.

According to an embodiment, the processor 120 of the electronic device 101 may receive information about the distance between the coil 323 and the display 250.

The processor 120 of the electronic device 101 may control the first battery 271 so that current is cut off to at least one electromagnet 290 when the distance between the coil 323 and the display 250 is equal to or less than a specific distance (1025). For example, when the distance between the coil 323 and the display 250 is equal to or less than a specific distance, it may be a state in which a user is using or intending to use the digital pen 300 of the electronic device 101. When the distance between the coil 323 and the display 250 is equal to or less than a specific distance, the processor 120 of the electronic device 101 may be configured to determine that a use event of the digital pen 300 occurs. When a use event of the digital pen 300 occurs, the processor 120 of the electronic device 101 may control the first battery 271 so that current is not applied to at least one electromagnet 290. At least one electromagnet 290 may not generate magnetic force when current is not applied.

The processor 120 of the electronic device 101 may control the first battery 271 so that current is applied to at least one electromagnet 290 when the distance between the coil 323 and the display 250 exceeds a specific distance (1023). For example, when the distance between the coil 323 and the display 250 exceeds a specific distance, it may be a state in which a user is not using the digital pen 300 of the electronic device 101. When the distance between the coil 323 and the display 250 exceeds a specific distance, the processor 120 of the electronic device 101 may be configured to determine that a non-use event of the digital pen 300 occurs. When a non-use event of the digital pen 300 occurs, the processor 120 of the electronic device 101 may control the first battery 271 so that current is applied to at least one electromagnet 290. At least one electromagnet 290 may generate magnetic force to form an attractive force with at least one magnetic member 340 of the digital pen 300 when current is applied.

According to an embodiment, the processor 120 of the electronic device 101 may be configured to control the first battery 271 or the power management module (e.g., the power management module 188 of FIG. 1) to apply current to at least one electromagnet 290 or to cut off current to at least one electromagnet 290.

FIG. 25A is a flowchart 1030 for describing a current application process for an electromagnet of an electronic device according to an embodiment of the disclosure.

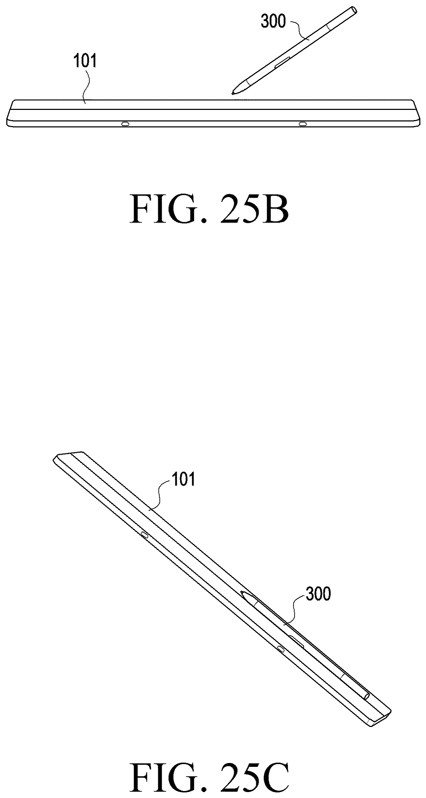

FIG. 25B is a perspective view illustrating a digital pen and an electronic device according to an embodiment of the disclosure.

FIG. 25C is a perspective view illustrating a digital pen and an electronic device according to an embodiment of the disclosure.

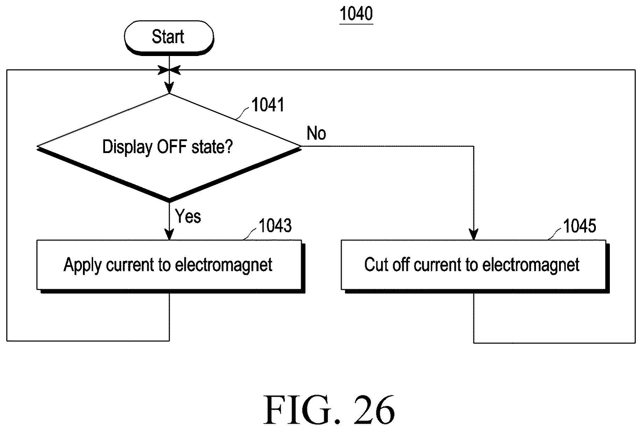

The embodiments of FIGS. 25A to 25C may be combined with the embodiments of FIGS. 1 to 24 or the embodiment of FIG. 26.

Referring to FIGS. 4, 7, 10, 25A, 25B, and 25C, the processor (e.g., the processor 120 of FIG. 1) of the electronic device 101 may be configured to identify whether the difference in acceleration sensor values is equal to or less than a specific value (1031). The difference in acceleration sensor values may be the difference between a first value measured from the acceleration sensor of the electronic device 101 and a second value measured from the acceleration sensor of the digital pen 300. The processor 120 of the electronic device 101 may be electrically connected to the communication module (e.g., the communication module 190 of FIG. 1) and may receive information about the second value measured from the acceleration sensor of the digital pen 300 from the communication circuit (e.g., the communication circuit 490 of FIG. 6) of the digital pen 300.

According to an embodiment, the acceleration sensor of the electronic device 101 and the acceleration sensor of the digital pen 300 may each be a 3-axis acceleration sensor configured to measure acceleration values in three-axis directions.

According to an embodiment, the processor 120 of the electronic device 101 may receive information about the first value measured from the acceleration sensor of the electronic device 101 and information about the second value measured from the acceleration sensor of the digital pen 300.

The processor 120 of the electronic device 101 may identify whether the difference between the first value and the second value is equal to or less than a specific value predesignated in the memory 130. For example, the specific value may be defined and/or interpreted as a threshold stored in the memory. For example, the processor 120 of the electronic device 101 may be configured to compare the first value and the second value for any one axis among the acceleration values in three-axis directions, but the processor 120 of the disclosure is not limited thereto and may be configured to compare the first value and the second value for each of two axes, or may be configured to compare the first value and the second value for each of three axes. Hereinafter, the case where the processor 120 of the electronic device 101 is configured to compare the difference between the first value and the second value for any one axis among the acceleration values in three-axis directions is described as an example, but the disclosure is not limited thereto. For example, the difference between the first value and the second value may be defined as an angle formed between the electronic device 101 and the digital pen 300. For example, when the difference between the first value and the second value exceeds a specific value (e.g., FIG. 25B), the digital pen 300 may be in a state of being held by a user or may be disposed at a predetermined angle with respect to the electronic device 101. For example, when the difference between the first value and the second value is equal to or less than a specific value (e.g., FIG. 25C), the digital pen 300 may be in a state of not being held by a user or may be disposed on at least a portion of the electronic device 101.

The processor 120 of the electronic device 101 may control the first battery 271 to apply current to at least one electromagnet 290 when the difference in acceleration sensor values is equal to or less than a specific value (e.g., FIG. 25C) (1033). For example, when the angle formed between the electronic device 101 and the digital pen 300 is equal to or less than a specific angle, it may be a state in which a user is not using the digital pen 300 of the electronic device 101. When the difference in acceleration sensor values is equal to or less than a specific value, the processor 120 of the electronic device 101 may be configured to determine that a non-use event of the digital pen 300 occurs. When a non-use event of the digital pen 300 occurs, the processor 120 of the electronic device 101 may control the first battery 271 so that current is applied to at least one electromagnet 290. At least one electromagnet 290 may generate magnetic force to form an attractive force with at least one magnetic member 340 of the digital pen 300 when current is applied.

The processor 120 of the electronic device 101 may control the first battery 271 to cut off current to at least one electromagnet 290 when the difference in acceleration sensor values exceeds a specific value (e.g., FIG. 25B) (1035). For example, when the angle formed between the electronic device 101 and the digital pen 300 exceeds a specific angle, it may be a state in which a user is using or intending to use the digital pen 300 of the electronic device 101. When the difference in acceleration sensor values exceeds a specific value, the processor 120 of the electronic device 101 may be configured to determine that a use event of the digital pen 300 occurs. When a use event of the digital pen 300 occurs, the processor 120 of the electronic device 101 may control the first battery 271 so that current is not applied to at least one electromagnet 290. At least one electromagnet 290 may not generate magnetic force when current is not applied.

According to an embodiment, the processor 120 of the electronic device 101 may be configured to control the first battery 271 or the power management module (e.g., the power management module 188 of FIG. 1) to apply current to at least one electromagnet 290 or to cut off current to at least one electromagnet 290.

FIG. 26 is a flowchart 1040 for describing a current application process for an electromagnet of an electronic device according to an embodiment of the disclosure.

The embodiment of FIG. 26 may be combined with the embodiments of FIGS. 1 to 25.

Referring to FIGS. 4, 7, 10, and 26, the processor (e.g., the processor 120 of FIG. 1) of the electronic device 101 may be configured to identify whether the flexible display 250 of the electronic device 101 is in an off state (1041). For example, the off state of the flexible display 250 may be defined and/or referred to as a state in which visual images are not implemented through the flexible display 250 or a state in which the flexible display 250 is turned off, and the on state of the flexible display 250 may be defined and/or referred to as a state in which visual images are implemented through the flexible display 250 or a state in which the flexible display 250 is turned on.

The processor 120 of the electronic device 101 may control the first battery 271 to apply current to at least one electromagnet 290 when the flexible display 250 of the electronic device 101 is in an off state (1043). For example, when the flexible display 250 of the electronic device 101 is in an off state, it may be a state in which a user is not using the digital pen 300 of the electronic device 101. When the flexible display 250 of the electronic device 101 is in an off state, the processor 120 of the electronic device 101 may control the first battery 271 so that current is applied to at least one electromagnet 290. At least one electromagnet 290 may generate magnetic force to form an attractive force with at least one magnetic member 340 of the digital pen 300 when current is applied.

The processor 120 of the electronic device 101 may control the first battery 271 to cut off current to at least one electromagnet 290 when the flexible display 250 of the electronic device 101 is in an on state (1045). For example, when the flexible display 250 of the electronic device 101 is in an on state, it may be a state in which a user is using or intending to use the digital pen 300 of the electronic device 101. When the flexible display 250 of the electronic device 101 is in an on state, the processor 120 of the electronic device 101 may be configured to determine that a use event of the digital pen 300 occurs. When a use event of the digital pen 300 occurs, the processor 120 of the electronic device 101 may control the first battery 271 so that current is not applied to at least one electromagnet 290. At least one electromagnet 290 may not generate magnetic force when current is not applied.

According to an embodiment, the processor 120 of the electronic device 101 may be configured to control the first battery 271 or the power management module (e.g., the power management module 188 of FIG. 1) to apply current to at least one electromagnet 290 or to cut off current to at least one electromagnet 290.

A foldable electronic device may have a flexible display that may be folded disposed over the entire area of the housing structure and may include a plurality of housing structures to support this. Therefore, the foldable electronic device may have various components disposed and/or mounted in each of the plurality of housing structures. As the functions of foldable electronic devices become more diverse, the number of components disposed and/or mounted inside foldable electronic devices is increasing. Since the overall size or inner space of a foldable electronic device is limited, it may be difficult to secure sufficient space for various components to be disposed and/or mounted.

Further, a foldable electronic device may be provided with a stylus pen for implementing a user's handwriting input. However, since the inner space of a foldable electronic device is limited, it may be difficult to secure space for the stylus pen to be stored inside the housing structure.

According to an embodiment of the disclosure, a digital pen and an electronic device including the same may be provided that provide a structure for accommodating the digital pen when the foldable electronic device is in a folded state.

The disclosure is not limited to the foregoing embodiments but various modifications or changes may rather be made thereto without departing from the spirit and scope of the disclosure.

According to an embodiment of the disclosure, a digital pen that may be accommodated in an accommodation space defined by a flexible display and an electronic device including the same may be provided.

According to an embodiment of the disclosure, an electronic device may be provided that may apply or cut off current to an electromagnet by distinguishing between a use state and a non-use state of a digital pen.

The effects obtainable from the disclosure are not limited to the effects mentioned above, and other effects not mentioned is clearly understood by those skilled in the art to which the disclosure pertains from the following description.

According to an embodiment of the disclosure, an electronic device 101 may include a housing 201, a display 250, or at least one electromagnet 290. The housing 201 may include a first housing 210, a second housing 220, or a hinge structure 231. The hinge structure may rotatably connect the first housing and the second housing relative to each other. The display may be disposed on the housing. The display may include a first display area 251, a second display area 252, or a folding area 253. The first display area may be disposed on the first housing. The second display area may be disposed on the second housing. The folding area may be configured to be at least partially foldable. The at least one electromagnet may be disposed between the hinge structure and the folding area. When the housing is in a folded state, the folding area may be configured to form an accommodation space capable of accommodating a digital pen 300 including at least one magnetic member 340 when the housing is in a folded state.

According to an embodiment, the at least one electromagnet may be configured to generate magnetic force by having current applied thereto when the housing is in a folded state. The at least one electromagnet may be configured not to generate magnetic force by having current cut off when the housing is in an unfolded state.

According to an embodiment, the display may include an electromagnetic induction panel. At least a portion of the electromagnetic induction panel may be configured to be located between the at least one electromagnet and the at least one magnetic member when the digital pen is accommodated in the accommodation space.

According to an embodiment, the electronic device may further include a first printed circuit board 241, a second printed circuit board 242, or a flexible printed circuit board 243. The first printed circuit board may be disposed inside the first housing. The second printed circuit board may be disposed inside the second housing. The flexible printed circuit board may be electrically connected to the first printed circuit board 241 and the second printed circuit board 242.

According to an embodiment, at least a portion of the flexible printed circuit board may be disposed on the hinge structure. The at least one electromagnet may be disposed on at least a partial area of the flexible printed circuit board disposed on the hinge structure.

According to an embodiment, the electronic device may further include a first battery 271. The first battery may be disposed in the first housing. The at least one electromagnet may be configured to have current applied thereto from the first battery.

According to an embodiment, the electronic device may further include a reinforcing member 281. The reinforcing member may be configured to limit the movement of the flexible printed circuit board. The reinforcing member may be fixed to the hinge structure.

According to an embodiment, the at least one electromagnet may be disposed on the reinforcing member.

According to an embodiment, the reinforcing member may include a first reinforcing member 281a or a second reinforcing member 281b. The second reinforcing member may be spaced apart from the first reinforcing member. The at least one electromagnet may include a first electromagnet 290a or a second electromagnet 290b. The first electromagnet may be disposed on the first reinforcing member. The second electromagnet may be disposed on the second reinforcing member.

According to an embodiment, the electronic device may include a first battery 271 or a second battery 272. The first battery may be disposed in the first housing. The second battery may be disposed in the second housing. The first electromagnet may be configured to have current applied thereto from the first battery. The second electromagnet may be configured to have current applied thereto from the second battery.

According to an embodiment, the at least one electromagnet may be configured not to generate magnetic force by having current cut off when a distance between the display and a coil of the digital pen is equal to or less than a designated specific value. The at least one electromagnet may be configured to generate magnetic force by having current applied thereto when the distance between the display and the coil of the digital pen is greater than the designated specific value.

According to an embodiment, the at least one electromagnet may be configured to generate magnetic force by having current applied thereto when the display is in a turned-on state. The at least one electromagnet may be configured not to generate magnetic force by having current cut off when the display is in a turned-off state.

According to an embodiment of the disclosure, an electronic device 101 may include a housing, a display 550, or at least one electromagnet 590. The housing may include a first housing 501, a second housing 502, a third housing 503, a first hinge structure 504, or a second hinge structure 505. The first hinge structure may rotatably connect the first housing and the second housing relative to each other. The second hinge structure may rotatably connect the second housing and the third housing relative to each other. The display may be disposed on the housing. The display may include a first display area 551, a second display area 552, a third display area 553, or a folding area 554, 555. The first display area may be disposed on the first housing. The second display area may be disposed on the second housing. The third display area may be disposed on the third housing. The folding area may be configured to be at least partially foldable. The at least one electromagnet may be disposed on the first hinge structure or the second hinge structure. The folding area may be configured to form an accommodation space capable of accommodating a digital pen 300 including at least one magnetic member 340 when the housing is in a folded state.

According to an embodiment, the folding area may include a first folding area 554 or a second folding area 555. The first folding area may connect the first display area and the second display area. The second folding area may connect the second display area and the third display area.

According to an embodiment, the at least one electromagnet may be disposed between the first hinge structure and the first folding area.

According to an embodiment, the at least one electromagnet may be disposed between the second hinge structure and the second folding area.

According to an embodiment of the disclosure, an electronic device 101 may include a housing 201, a display 250, at least one electromagnet 290, a battery 271, at least one processor 120, or a memory 130. The housing may include a first housing 210, a second housing 220, or a hinge structure 231. The hinge structure may include a hinge structure 231 rotatably connecting the first housing and the second housing relative to each other. The display may be disposed on the housing. The display may include a first display area 251, a second display area 252, or a folding area 253. The first display area may be disposed on the first housing. The second display area may be disposed on the second housing. The folding area may be configured to be at least partially foldable. The at least one electromagnet 290 may be disposed between the hinge structure and the folding area. The battery may be configured to apply current to the at least one electromagnet. The at least one processor may be configured to control the battery to apply current to the at least one electromagnet when a non-use event of a digital pen 300 occurs. The at least one processor may be configured to control the battery to cut off current to the at least one electromagnet when a use event of the digital pen 300 occurs.

According to an embodiment, the at least one processor may be configured to determine that the non-use event of the digital pen occurs when a folding angle of the housing is equal to or less than a specific angle stored in the memory. The at least one processor may be configured to determine that the use event of the digital pen occurs when the folding angle of the housing exceeds the specific angle.

According to an embodiment, the at least one processor may be configured to determine that the use event of the digital pen occurs when a distance between the display and a coil of the digital pen is equal to or less than a specific distance. The at least one processor may be configured to determine that the non-use event of the digital pen occurs when the distance between the display and the coil of the digital pen exceeds the specific distance.

According to an embodiment, the at least one processor may be configured to determine that the non-use event of the digital pen occurs when a difference between a first value measured from an acceleration sensor of the electronic device and a second value measured from an acceleration sensor of the digital pen is equal to or less than a specific value. The at least one processor may be configured to determine that the use event of the digital pen occurs when the difference between the first value measured from the acceleration sensor of the electronic device and the second value measured from the acceleration sensor of the digital pen exceeds the specific value.

According to an embodiment, the at least one processor may be configured to determine that the non-use event of the digital pen occurs when the display is in an off state. The at least one processor may be configured to determine that the use event of the digital pen occurs when the display is in an on state.

While the disclosure has been shown and described with reference to exemplary embodiments thereof, it will be apparent to those of ordinary skill in the art that various changes in form and detail may be made thereto without departing from the spirit and scope of the disclosure as defined by the following claims.

## Claims

1. An electronic device (101) comprising:
a housing (201) including a first housing (210), a second housing (220) and a hinge structure (231) rotatably connecting the first housing and the second housing relative to each other;
a display (250) disposed on the housing, and including a first display area (251) disposed on the first housing, a second display area (252) disposed on the second housing, and a folding area (253) configured to be at least partially foldable; and
at least one electromagnet (290) disposed between the hinge structure and the folding area,
wherein, when the housing is in a folded state, the folding area is configured to form an accommodation space (258) capable of accommodating a digital pen (300) including at least one magnetic member (340).

2. The electronic device of claim 1, wherein, when the housing is in the folded state, the at least one electromagnet is configured to generate a magnetic force by having current applied thereto, and
Wherein, when the housing is in an unfolded state, the at least one electromagnet is configured not to generate the magnetic force by having current cut off .

3. The electronic device of any one of claims 1 to 2, wherein the display includes an electromagnetic induction panel, and
Wherein, when the digital pen is accommodated in the accommodation space, at least a portion of the electromagnetic induction panel is configured to be located between the at least one electromagnet and the at least one magnetic member.

4. The electronic device of any one of claims 1 to 3, further comprising:
a first printed circuit board (241) disposed inside the first housing;
a second printed circuit board (242) disposed inside the second housing; and
a flexible printed circuit board (243) electrically connected to the first printed circuit board (241) and the second printed circuit board (242).

5. The electronic device of any one of claims 1 to 4, wherein at least a portion of the flexible printed circuit board is disposed on the hinge structure, and
wherein the at least one electromagnet is disposed on the at least a portion of the flexible printed circuit board disposed on the hinge structure.

6. The electronic device of any one of claims 1 to 5, further comprising a first battery (271) disposed in the first housing,
wherein the at least one electromagnet is configured to have current applied thereto from the first battery.

7. The electronic device of any one of claims 1 to 6, further comprising: a reinforcing member (281) configured to limit a movement of the flexible printed circuit board and fixed to the hinge structure, and
wherein the at least one electromagnet is disposed on the reinforcing member.

8. The electronic device of any one of claims 1 to 7, wherein the reinforcing member includes a first reinforcing member (281a) and a second reinforcing member (281b) spaced apart from the first reinforcing member, and
wherein the at least one electromagnet includes a first electromagnet (290a) disposed on the first reinforcing member and a second electromagnet (290b) disposed on the second reinforcing member.

9. The electronic device of any one of claims 1 to 8, further comprising:
a first battery (271) disposed in the first housing; and
a second battery (272) disposed in the second housing,
wherein the first electromagnet is configured to have current applied thereto from the first battery, and
wherein the second electromagnet is configured to have current applied thereto from the second battery.

10. The electronic device of any one of claims 1 to 9, wherein the at least one electromagnet is configured not to generate a magnetic force by having current cut off when a distance between the display and a coil of the digital pen is equal to or less than a designated specific value, and
wherein the at least one electromagnet is configured to generate a magnetic force by having current applied thereto when the distance between the display and the coil of the digital pen is greater than the designated specific value.

11. The electronic device of any one of claims 1 to 10, wherein, when the display is in a turned-on state, the at least one electromagnet is configured to generate a magnetic force by having current applied thereto, and
Wherein, when the display is in a turned-off state, the at least one electromagnet is configured not to generate a magnetic force by having current cut off.

12. An electronic device (101) comprising:
a housing including a first housing (501), a second housing (502), a third housing (503), a first hinge structure (504) rotatably connecting the first housing and the second housing relative to each other, and a second hinge structure (505) rotatably connecting the second housing and the third housing relative to each other;
a display (550) disposed on the housing, and including a first display area (551) disposed on the first housing, a second display area (552) disposed on the second housing, a third display area (553) disposed on the third housing, and a folding area (554, 555) configured to be at least partially foldable; and
at least one electromagnet (590) disposed on the first hinge structure or the second hinge structure,
wherein, when the housing is in a folded state, the folding area is configured to form an accommodation space (558) capable of accommodating a digital pen (300) including at least one magnetic member (340).

13. The electronic device of claim 12,
wherein the folding area includes:
a first folding area (554) connecting the first display area and the second display area;
and
a second folding area (555) connecting the second display area and the third display area.

14. The electronic device of claim 12 or 13,
wherein the at least one electromagnet is disposed between the first hinge structure and the first folding area.

15. The electronic device of any one of claims 12 to 14,
wherein the at least one electromagnet is disposed between the second hinge structure and the second folding area.
